# EUROPEAN PATENT APPLICATION

(11) **EP 1 884 999 A1**
(43) Date of publication of application: **06.02.2008**
(21) Application number: 06756859.2
(22) Date of filing: 25.05.2006
(51) Int. Cl.: H01L 29/12, H01L 21/336, H01L 29/78, H01L 29/786

(54) **SEMICONDUCTOR DEVICE AND METHOD FOR MANUFACTURING SAME**

(30) Priority: 27.05.2005 JP 2005155363; 27.03.2006 JP 2006086553
(71) Applicant: TOYOTA JIDOSHA KABUSHIKI KAISHA, Toyota-shi, Aichi-ken, 471-8571 (JP)
(72) Inventor: SUGIMOTO, Masahiro, TOYOTA JIDOSHA K.K., Toyota-shi, Aichi 4718571 (JP); KACHI, Tetsu, K.K. TOYOTA CHUO KENKYUSHO, Aichi-gun, Aichi 4801192 (JP); UESUGI, Tsutomu, K.K. TOYOTA CHUO KENKYUSHO, Aichi-gun, Aichi 4801192 (JP); UEDA, Hiroyuki, K.K. TOYOTA CHUO KENKYUSHO, Aichi-gun, Aichi 4801192 (JP); SOEJIMA, Narumasa, K.K. TOYOTA CHUO KENKYUSHO, Aichi-gun, Aichi 4801192 (JP)
(74) Representative: Winter, Brandl, Fürniss, Hübner Röss, Kaiser, Polte Partnerschaft Patent- und Rechtsanwaltskanzlei
(86) International application number: PCT/JP2006/310939
(87) International publication number: WO 2006/126726

(57) **Abstract**

The present invention aims to suppress the diffusion of p-type impurities (typically magnesium), included in a semiconductor region of a III-V compound semiconductor, into an adjoining different semiconductor region. A semiconductor device 10 of the present invention comprises a first semiconductor region 28 of gallium nitride (GaN) including p-type impurities that consist of magnesium, a second semiconductor region 34 of gallium nitride, and an impurity diffusion suppression layer 32 of silicon oxide (SiO₂) located between the first semiconductor region 28 and the second semiconductor region 34.

## Description

The present application claims priority based on Japanese Patent Application 2005-155363 filed on May 27, 2005 and Japanese Patent Application 2006-086553 filed on March 27, 2006, the contents of which are hereby incorporated by reference within this application.

### Technical Field

The present invention relates to a semiconductor device adopting III-V compound semiconductors. In particular, the present invention relates to a semiconductor device comprising a structure for suppressing the phenomenon where p-type impurities included in a semiconductor region diffuse to an adjoining semiconductor region. The present invention further relates to a method of manufacturing this type of semiconductor device.

### Background Art

There is ongoing development of semiconductor devices adopting III-V compound semiconductors. III-V compound semiconductors have high breakdown field strength and high saturated electron mobility. It is thus to be expected that semiconductor devices adopting III-V compound semiconductors are utilized as switching devices. Various types of configuration have been proposed for this type of semiconductor device. For example, there is ongoing development of semiconductor devices that have a heterojunction comprising a semiconductor layer of a III-V compound semiconductor that has a narrow band gap and a semiconductor layer of a III-V compound semiconductor that has a wide band gap.
Semiconductor devices that have the heterojunction utilize the phenomenon wherein electrons travel through a two-dimensional electron gas layer formed at the heterojunction surface. The travel of the electrons can be suppressed utilizing gate voltage if both a gate insulator layer and a gate electrode are formed facing the heterojunction, and the semiconductor device can be switched on and off. Usually the type of semiconductor device that utilizes III-V compound semiconductors is a normally-on type in which the travel of electrons is halted when a negative gate voltage is applied, and in which the electrons travel when gate voltage is not being applied.
There is a need for normally-off type switching semiconductor devices which are easy to use safely and which have a wide range of applications. Japanese Publication No. 2004-260140 of unexamined patent application sets forth a normally-off type switching semiconductor device. Japanese Publication No. 2004-260140 teaches a technique for forming a semiconductor region that includes p-type impurities at an area of adjoining the semiconductor layer, which has a narrow band gap and forms the heterojunction. When gate voltage is not being applied, the semiconductor region that includes p-type impurities depletes the semiconductor layer with the narrow band gap that forms the heterojunction. As a result, by providing the semiconductor region that includes p-type impurities, it is possible to create a state wherein a two-dimensional electron gas layer is not formed at the heterojunction surface when gate voltage is not being applied. Consequently, by providing the semiconductor region that includes p-type impurities, a normally-off type semiconductor device is obtained in which the travel of the electrons is halted when gate voltage is not being applied, and in which the electrons travel when positive gate voltage is being applied.

### Disclosure of the Invention

Magnesium is usually utilized as the p-type impurity in III-V compound semiconductors. Magnesium diffuses easily. For example, magnesium when added to gallium nitride has an extremely fast diffusion velocity. As a result, in the aforementioned semiconductor device having the heterojunction, magnesium added to the semiconductor region may diffuse into a semiconductor layer that forms the heterojunction, changing the threshold value or the threshold voltage of the gate electrode. For this reason, a technique is desired for the aforementioned semiconductor device that will suppress the diffusion of magnesium and adjust the threshold value to the desired value. This problem is considerable when magnesium is utilized as the p-type impurity. However, the same type of problem is present even when p-type impurities other than magnesium are utilized. With the miniaturization of semiconductor devices, a phenomenon cannot be avoided wherein the p-type impurities diffuse into the semiconductor layer forming the heterojunction even in cases where p-type impurities other than magnesium are utilized.
Moreover, this type of problem is not limited to semiconductor devices that have the heterojunction. In various situations it can be difficult, due to a large amount of p-type impurities diffused into a semiconductor region from an adjoining semiconductor region originally including p-type impurities, to obtain a semiconductor device provided with the desired characteristics.
The present invention aims to present a technique for suppressing the phenomenon where, in a semiconductor device comprising a semiconductor region that includes p-type impurities, the p-type impurities diffuse into an adjoining different semiconductor region. The present invention thus aims to present a semiconductor device in which the desired characteristics are easily realized. The present invention further aims to present a method of manufacturing this type of semiconductor device.

The present invention is characterized by being provided with an impurity diffusion suppression layer for suppressing the diffusion of p-type impurities. This impurity diffusion suppression layer is formed between a semiconductor region and another semiconductor region. The diffusion of p-type impurities into an adjoining different semiconductor region can be suppressed by providing the impurity diffusion suppression layer, and it is possible to prevent a deterioration of the characteristics of the semiconductor device. It is consequently possible to obtain a semiconductor device with the desired characteristics based on pre-set impurity concentration and thickness, etc.

A semiconductor device of the present invention comprises a first semiconductor region of a III-V compound semiconductor including p-type impurities, a second semiconductor region of a III-V compound semiconductor, and an impurity diffusion suppression layer interposed between the first semiconductor region and the second semiconductor region.
The semiconductor device may further comprise a gate electrode facing the first semiconductor region with the impurity diffusion suppression layer and the second semiconductor region being interposed between the gate electrode and the first semiconductor region. In this case, the first semiconductor region, the impurity diffusion suppression layer, the second semiconductor region, and the gate electrode form a field effect type gate configuration. In this gate configuration a channel is formed in the second semiconductor region, or a channel is formed between the gate electrode and the second semiconductor region.
When this gate configuration is provided with the first semiconductor region that includes p-type impurities, a depleted layer extends between the gate electrode and the first semiconductor region while gate-on voltage is not being applied to the gate electrode, and carriers are prevented from traveling along the channel. As a result, a semiconductor device that has this gate configuration can operate as a normally-off type. Furthermore, in this gate configuration, the impurity diffusion suppression layer is capable of suppressing the diffusion of p-type impurities from the first semiconductor region into the second semiconductor region. It is consequently easy to realize any desired threshold values with this gate configuration.
The semiconductor device of the present invention may further comprise a third semiconductor region interposed between the second semiconductor region and the gate electrode. The third semiconductor region is made of a III-V compound semiconductor which has a wider band gap than the band gap of the second semiconductor region. With this gate configuration, the second semiconductor region and the third semiconductor region form a heterojunction. As a result, the carriers can travel along a two-dimensional electron gas layer formed between the second semiconductor region and the third semiconductor region when gate-on voltage is applied to the gate electrode. The channel resistance of this gate configuration can be reduced by providing the third semiconductor region.

Another semiconductor device of the present invention is capable of being realized as a semiconductor device that has an electron travel region along which electrons travel. The semiconductor device of the present invention comprises a first semiconductor region, an impurity diffusion suppression layer, a second semiconductor region, and a gate electrode, wherein the first semiconductor region, the impurity diffusion suppression layer, the second semiconductor region, and the gate electrode are arranged in that order. The first semiconductor region is made of a III-V compound semiconductor including p-type impurities. The second semiconductor region is made of a III-V compound semiconductor including n-type impurities. The impurity diffusion suppression layer suppresses the diffusion of p-type impurities from within the first semiconductor region to the second semiconductor region.
In the aforementioned semiconductor device, the electrons travel within the second semiconductor region. The second semiconductor region is an electron travel region. The travel of electrons within the second semiconductor region is controlled by a magnitude of voltage applied to the gate electrode. When the impurity diffusion suppression layer is interposed between the first semiconductor region and the second semiconductor region, it is possible to suppress the diffusion of p-type impurities from the first semiconductor region into the second semiconductor region. It is consequently possible, based on the pre-set impurity concentration and thickness, etc. of the second semiconductor region, to adjust the magnitude of the threshold voltage such that it achieves the desired magnitude. The aforementioned semiconductor device provides a configuration in which it is easy to adjust the threshold voltage.

Another semiconductor device of the present invention is capable of being realized as a semiconductor device with a heterojunction. The semiconductor device of the present invention comprises a first semiconductor region, an impurity diffusion suppression layer, a second semiconductor region, a third semiconductor region, and a gate electrode, wherein the first semiconductor region, the impurity diffusion suppression layer, the second semiconductor region, the third semiconductor region, and the gate electrode are arranged in that order. The first semiconductor region is made of a III-V compound semiconductor that includes p-type impurities. The second semiconductor region is made of a III-V compound semiconductor. The third semiconductor region is made of a III-V compound semiconductor which has a wider band gap than the band gap of the second semiconductor region. The impurity diffusion suppression layer suppresses the diffusion of p-type impurities from within the first semiconductor region to the second semiconductor region.
In the aforementioned semiconductor device, a heterojunction is formed by the second semiconductor region and the third semiconductor region. A two-dimensional electron gas layer is formed at the heterojunction surface. The first semiconductor region faces this heterojunction. By depleting the second semiconductor region, the first semiconductor region creates a state in which the two-dimensional electron gas layer does not exist when gate-on voltage is not being applied. Since the impurity diffusion suppression layer is interposed between the first semiconductor region and the second semiconductor region, the diffusion of p-type impurities from within the first semiconductor region to the second semiconductor region is suppressed. It is consequently possible, based on the pre-set impurity concentration and thickness, etc. of the second semiconductor region, to adjust a magnitude of the threshold voltage such that it achieves the desired value. The aforementioned semiconductor device provides a configuration in which it is easy to adjust the threshold voltage.
Another semiconductor region may be interposed at each interface between the first semiconductor region, the impurity diffusion suppression layer, the second semiconductor region, and the third semiconductor region. For example, a semiconductor region that has a band gap narrower than the band gap of the third semiconductor region, which also has a low impurity concentration, may be interposed between the second semiconductor region and the third semiconductor region. This semiconductor region is capable of generating a two-dimensional electron gas layer that has low resistance.

In the semiconductor device that has the electron travel region, it is preferred that an insulator layer is formed between the second semiconductor region and the gate electrode. A useful gate configuration can thus be obtained in which high voltage can be applied to the gate electrode.
In the semiconductor device that has the heterojunction, it is also preferred that an insulator layer is formed between the third semiconductor region and the gate electrode. A useful gate configuration can thus be obtained in which high voltage can be applied to the gate electrode.

The present invention is capable of being realized as a vertical type semiconductor device that has an electron travel region.

This semiconductor device comprises a drain electrode, a drain layer formed on the drain electrode and made of a III-V compound semiconductor including a high concentration of n-type impurities, and a low concentration semiconductor region formed on the drain layer and made of a III-V compound semiconductor including a low concentration of n-type impurities. The semiconductor device of the present invention further comprises a plurality of first semiconductor regions formed on the low concentration semiconductor region and made of a III-V compound semiconductor that includes p-type impurities, wherein the first semiconductor regions are distributed on the low concentration semiconductor region such that a space is left between adjacent first semiconductor regions. The semiconductor device of the present invention further comprises an impurity diffusion suppression layer formed on the first semiconductor regions. The semiconductor device of the present invention further comprises a second semiconductor region formed on the low concentration semiconductor region and the impurity diffusion suppression layer, wherein the second semiconductor region is made of a III-V compound semiconductor that includes n-type impurities. The second semiconductor region is a region through which electrons travel. The semiconductor device of the present invention further comprises a gate insulator layer formed on at least a part of the second semiconductor region, wherein that part of the second semiconductor region faces the first semiconductor region, and a gate electrode formed on the gate insulator layer. The semiconductor device of the present invention further comprises a source electrode that makes electrical contact with a part of the second semiconductor region, wherein that part of the second semiconductor region faces the first semiconductor region. Since, in the semiconductor device of the present invention, the source electrode is formed with the aforementioned configuration, on and off switching of the device can be performed by the gate electrode.

The present invention is capable of being realized as a vertical type semiconductor device that has the heterojunction.
This semiconductor device comprises a drain electrode, a drain layer formed on the drain electrode and made of a III-V compound semiconductor including n-type impurities of high concentration, and a low concentration semiconductor region formed on the drain layer and made of a III-V compound semiconductor including n-type impurities of low concentration. The semiconductor device of the present invention further comprises a plurality of first semiconductor regions formed on the low concentration semiconductor region and made of a III-V compound semiconductor that includes p-type impurities, wherein the first semiconductor regions are distributed on the low concentration semiconductor region such that a space is left between adjacent first semiconductor regions. The semiconductor device of the present invention further comprises an impurity diffusion suppression layer formed on the first semiconductor regions. The semiconductor device of the present invention further comprises a second semiconductor region formed on the low concentration semiconductor region and the impurity diffusion suppression layer, wherein the second semiconductor region is made of a III-V compound semiconductor, and a third semiconductor region formed on the second semiconductor region, wherein the third semiconductor region is made of a III-V compound semiconductor which has a wider band gap than the band gap of the second semiconductor region. The second semiconductor region and the third semiconductor region form the heterojunction. The semiconductor device of the present invention further comprises a gate insulator layer formed on at least a part of the third semiconductor region, wherein that part of the third semiconductor region faces the first semiconductor region, and a gate electrode formed on the gate insulator layer. The semiconductor device of the present invention further comprises a source electrode making electrical contact with a part of the third semiconductor region, wherein that part of the third semiconductor region faces the first semiconductor region. Since the source electrode is formed with the aforementioned configuration in the semiconductor device of the present invention, on and off switching of the device can be performed by the gate electrode.

In the vertical type semiconductor device that has the electron travel region, or in the vertical type semiconductor device that has the heterojunction, it is preferred that the source electrode also makes electrical contact with the first semiconductor regions.
In this case, the potential of the first semiconductor regions can be stabilized. As a result, a depleted layer is formed within the second semiconductor region when gate-on voltage is not applied to the gate electrode, and the semiconductor device can realize a stable normally-off operation.

In the vertical type semiconductor device that has the electron travel region, or in the vertical type semiconductor device that has the heterojunction, a part of the low concentration semiconductor region is interposed between the adjacent first semiconductor regions. The current flowing between the drain electrode and the source electrode flows vertically along the low concentration semiconductor region formed between the adjacent first semiconductor regions. By forming the first semiconductor regions in a distributed manner on the low concentration semiconductor region, it is possible to make the area along which the current flows vertically distributed in an wide area in a horizontal plane within the low concentration semiconductor region. Resistance of the semiconductor device can consequently be reduced.

In the vertical type semiconductor device that has the electron travel region, or in the vertical type semiconductor device that has the heterojunction, it is preferred that the semiconductor device further comprises a side surface impurity diffusion suppression layer located between the first semiconductor region and the low concentration semiconductor region located in the space between adjacent first semiconductor regions.
The side surface impurity diffusion suppression layer suppresses the diffusion of the p-type impurities included in the first semiconductor regions into the low concentration semiconductor region, located in the space between adjacent first semiconductor regions. A part of the low concentration semiconductor region is a path along which current flows vertically. As a result, it is possible to suppress any increase in resistance by suppressing the diffusion of p-type impurities into this part of the low concentration semiconductor region.

In the vertical type semiconductor device that has the electron travel region, or in the vertical type semiconductor device that has the heterojunction, it is preferred that the semiconductor device further comprise a bottom surface impurity diffusion suppression layer formed between the low concentration semiconductor region and a bottom surface of the first semiconductor region.
A pair of main electrodes is arranged in the vertical direction in the vertical semiconductor device. As a result, the low concentration semiconductor region disposed below the first semiconductor region is the region that must bear the voltage applied to the semiconductor device in the vertical direction. There is a decline in the breakdown voltage of the semiconductor device when p-type impurities diffuse into this low concentration semiconductor region. The bottom surface impurity diffusion suppression layer suppresses the diffusion of the p-type impurities included in the first semiconductor region into the low concentration semiconductor region disposed below the first semiconductor region. The semiconductor device can consequently be made capable of retaining a high breakdown voltage by providing the bottom surface impurity diffusion suppression layer.

The present invention is capable of being realized as a plane type semiconductor device that has an electron travel region.

This semiconductor device comprises a low concentration semiconductor region made of a III-V compound semiconductor that includes a low concentration of n-type impurities, and a first semiconductor region formed on a part of the low concentration semiconductor region and made of a III-V compound semiconductor that includes p-type impurities. The semiconductor device of the present invention further comprises an impurity diffusion suppression layer formed on the first semiconductor region. The semiconductor device of the present invention further comprises a second semiconductor region formed on the low concentration semiconductor region and the impurity diffusion suppression layer, wherein the second semiconductor region is made of a III-V compound semiconductor that includes n-type impurities. The second semiconductor region is a region through which electrons travel. The semiconductor device of the present invention further comprises a gate insulator layer formed on at least a part of the second semiconductor region, wherein that part of the second semiconductor region faces the first semiconductor region. The semiconductor device of the present invention further comprises a source electrode that makes electrical contact with a part of the second semiconductor region, wherein that part of the second semiconductor region faces the first semiconductor region, and a drain electrode making electrical contact with a part of the second semiconductor region, wherein that part of the second semiconductor region does not face the first semiconductor region. The semiconductor device of the present invention further comprises a gate electrode formed on the gate insulator layer between the source electrode and the drain electrode.

The present invention is also capable of being realized as a planer type semiconductor device that has a heterojunction.
This semiconductor device comprises a low concentration semiconductor region made of a III-V compound semiconductor that includes n-type impurities, and a first semiconductor region formed on a part of the low concentration semiconductor region and made of a III-V compound semiconductor that includes p-type impurities. The semiconductor device of the present invention further comprises an impurity diffusion suppression layer formed on the first semiconductor region. The semiconductor device of the present invention further comprises a second semiconductor region formed on the low concentration semiconductor region and the impurity diffusion suppression layer, wherein the second semiconductor region is made of a III-V compound semiconductor, and a third semiconductor region formed on the second semiconductor region, wherein the third semiconductor region is made of a III-V compound semiconductor which has a wider band gap than the band gap of the second semiconductor region. The semiconductor device of the present invention further comprises a gate insulator layer formed on at least a part of the third semiconductor region, wherein that part of the third semiconductor region faces the first semiconductor region. The semiconductor device of the present invention further comprises a source electrode that makes electrical contact with a part of the third semiconductor region, wherein that part of the third semiconductor region faces the first semiconductor region, and a drain electrode that makes electrical contact with a part of the third semiconductor region, wherein that part of the third semiconductor region does not face the first semiconductor region. The semiconductor device of the present invention further comprises a gate electrode formed on the gate insulator layer between the source electrode and the drain electrode.

In the planer type semiconductor device that has the electron travel region, or in the planer type semiconductor device that has the heterojunction, it is preferred that the source electrode also makes contact with the first semiconductor region. In this case, the potential of the first semiconductor region can be stabilized. As a result, a depleted layer is formed within the second semiconductor region when gate-on voltage is not applied to the gate electrode, and the semiconductor device can realize a stable normally-off operation.

In the planer type semiconductor device that has the electron travel region, or in the planer type semiconductor device that has the heterojunction, it is preferred that the semiconductor device further comprise a side surface impurity diffusion suppression layer located between a side face of the first semiconductor region and the low concentration semiconductor region.
A pair of main electrodes is arranged along a surface of the planer type semiconductor device. As a result, the low concentration semiconductor region, disposed laterally with respect to the first semiconductor region, is the region that must bear the voltage applied to the semiconductor device in the horizontal direction. There is a decline in the breakdown voltage of the semiconductor device when p-type impurities diffuse into this low concentration semiconductor region. The side surface impurity diffusion suppression layer suppresses the diffusion of the p-type impurities included in the first semiconductor region into the low concentration semiconductor region, disposed laterally with respect to the first semiconductor region. Consequently, by providing the side surface impurity diffusion suppression layer, the semiconductor device can be made capable of maintaining a high breakdown voltage.

It is preferred that in the semiconductor devices of the present invention, the impurity diffusion suppression layer is made of one layer or a stack of layers, with the single layer including one kind of material selected from a group consisting of silicon oxide, silicon nitride, aluminum nitride, and aluminum gallium nitride, wherein the stack of layers includes at least one layer including one kind of material and another layer including another kind of material.
These materials are capable of effectively suppressing the diffusion of the p-type impurities. Furthermore, these materials can be manufactured utilizing existing semiconductor processing techniques.

The present invention is effective for semiconductor devices that adopt magnesium as the p-type impurity.
The magnesium added to the III-V compound semiconductors as p-type impurities has an extremely high diffusion speed. However, the semiconductor devices of the present invention, by providing the impurity diffusion suppression layer, suppress the diffusion of the magnesium included in the first semiconductor region into the second semiconductor region. Consequently, even when magnesium is utilized as the p-type impurities, a semiconductor device can be obtained in which the threshold voltage is easily adjusted.

In the semiconductor devices of the present invention, it is preferred that the III-V compound semiconductors are Al_{X}Ga_{Y}In_{1-X-Y}N (0≤X≤1, 0≤Y≤1, 0≤(1-X-Y)≤1).
Since this material has a high breakdown field strength and high saturated electron mobility, semiconductor devices adopting the above material can realize a high breakdown voltage and a high frequency operation. The diffusion of p-type impurities is known to cause problems. However, the present invention is capable of dealing with these problems and consequently a practical semiconductor device can be obtained by utilizing an Al_{X}Ga_{Y}In_{1-X-Y}N semiconductor material that also has useful characteristic.

The present invention is also capable of presenting a method of manufacturing the aforementioned semiconductor devices.
A method of manufacturing a semiconductor device of the present invention comprises patterning an impurity diffusion suppression layer on a plurality of portions of a top surface of stacked semiconductor layers which comprise a lower semiconductor layer and an upper semiconductor layer, wherein the lower semiconductor layer is made of a III-V compound semiconductor that includes n-type impurities and the upper semiconductor layer is made of a III-V compound semiconductor that includes p-type impurities; and etching the upper semiconductor layer, at a region thereof that is not covered by the impurity diffusion suppression layer, so that a plurality of trenches penetrates the upper semiconductor layer and reaches the lower semiconductor layer. The manufacturing method of the present invention further comprises growing a crystal of a III-V compound semiconductor that includes n-type impurities from a surface of the lower semiconductor layer at a bottom surface of each trench.
With the manufacturing method of the present invention, it is preferred that the impurity diffusion suppression layer also works as a crystal growth suppression layer. In this case, the step of the crystal growth is continued until a crystal grows laterally above the impurity diffusion suppression layer from the crystal grown from the bottom of each trench.

Another method of manufacturing a semiconductor device of the present invention comprises patterning a crystal growth suppression layer on a plurality of portions on a top surface of a semiconductor layer, wherein the semiconductor layer is made of a III-V compound semiconductor that includes n-type impurities; and etching the semiconductor layer, at a region thereof that is not covered by the crystal growth suppression layer, so that a plurality of trenches penetrates into the semiconductor layer. The manufacturing method of the present invention further comprises forming an impurity diffusion suppression layer on the side surfaces and the bottom surface of each trench. The manufacturing method of the present invention further comprises removing the impurity diffusion suppression layer formed at the bottom surface of each trench and leaving the impurity diffusion suppression layers formed at the side surfaces of each trench by using the anisotropic etching technique so that side surface impurity diffusion suppression layers are formed on the side surfaces of each trench. The manufacturing method of the present invention further comprises growing a crystal of a III-V compound semiconductor that includes p-type impurities from a surface of the semiconductor layer at the bottom of each trench to form first semiconductor regions, wherein the first semiconductor region does not grow on the crystal growth suppression layer on the semiconductor layer. Since the crystal growth suppression layer is still present during this step, it is possible to form the first semiconductor regions by means of crystal growth only within the trenches. Furthermore, the manufacturing method of the present invention may comprise forming an upper surface impurity diffusion suppression layer on the first semiconductor regions, wherein the upper surface impurity diffusion suppression layer is not formed on the crystal growth suppression layer on the semiconductor layer. Since the crystal growth suppression layer is still present during this step, also, it is possible to form the upper surface impurity diffusion suppression layer only on the upper surfaces of the first semiconductor regions. The manufacturing method of the present invention further comprises a step of removing the crystal growth suppression layer on the upper surface of the semiconductor layer. The manufacturing method of the present invention further comprises a step of growing a crystal of a III-V compound semiconductor from the surface of the upper surface impurity diffusion suppression layer and the surface of the semiconductor layer to form a second semiconductor region. In the case where the second semiconductor region is utilized as an electron travel region, it is preferred that n-type impurities are introduced into the second semiconductor region. In the case where a heterojunction utilizing the second semiconductor region is formed, it is preferred that the manufacturing method of the present invention further comprises growing a crystal of a third semiconductor region from the surface of the second semiconductor layer, wherein the third semiconductor region is made of a III-V compound semiconductor which has a wider band gap than the band gap of the second semiconductor region.

The manufacturing method of the present invention has a specific feature that the crystal growth suppression layer is utilized for multipurpose. That is, the crystal growth suppression layer is utilized in forming trenches at upper potion of the semiconductor layer, growing the first first semiconductor regions at selected potions, and forming the upper surface impurity diffusion suppressing layer at selected areas. The crystal growth suppression layer performs a plurality of roles throughout the entire process in the manufacturing method of the present invention. As a result, the number of steps in the manufacturing method of the present invention can be substantially reduced.

Another method of manufacturing a semiconductor device of the present invention comprises patterning a crystal growth suppression layer on a plurality of portions on a top surface of a semiconductor layer, wherein the semiconductor layer is made of a III-V compound semiconductor that includes n-type impurities, and etching the semiconductor layer, at a region thereof that is not covered by the crystal growth suppression layer, so that a plurality of trenches penetrates into the semiconductor layer. The manufacturing method of the present invention further comprises forming an impurity diffusion suppression layer on the side surfaces and the bottom surface of each trench so that a bottom surface impurity diffusion suppression layer is formed at the bottom surface of each trench and side surface impurity diffusion suppression layers are formed at the side surfaces of each trench. The manufacturing method of the present invention further comprises growing a crystal of a III-V compound semiconductor that includes p-type impurities from a surface of the bottom surface impurity diffusion suppression layer at the bottom of each trench to form first semiconductor regions, wherein the first semiconductor region does not grow on the crystal growth suppression layer on the semiconductor layer. Since the crystal growth suppression layer is present during this step, it is possible to form the first semiconductor regions by means of crystal growth only within trenches. Furthermore, the manufacturing method of the present invention may comprise forming an upper surface impurity diffusion suppression layer on the first semiconductors, wherein the upper surface impurity diffusion suppression layer is not formed on the crystal growth suppression layer on the semiconductor layer. Since the crystal growth suppression layer is still present during this step, also, it is possible to form the upper surface impurity diffusion suppression layer only on the upper surfaces of the first semiconductor regions. The manufacturing method of the present invention further comprises removing the crystal growth suppression layer on the upper surface of the semiconductor layer. The manufacturing method of the present invention further comprises growing a crystal of a III-V compound semiconductor from the surface of the upper surface impurity diffusion suppression layer and the surface of the semiconductor layer to form a second semiconductor region. In the case where the second semiconductor region is utilized as an electron travel region, it is preferred that n-type impurities are introduced into the second semiconductor region. In the case where a heterojunction utilizing the second semiconductor region is formed, it is preferred that the manufacturing method of the present invention further comprises growing a crystal of a third semiconductor region from the surface of the second semiconductor region, wherein the third semiconductor region is made of a III-V compound semiconductor which has a wider band gap than the band gap of the second semiconductor region.
The manufacturing method of the present invention has a specific feature that the crystal growth suppression layer performs multifunction. That is, the crystal growth suppression layer is utilized in forming trenches at upper portion of the semiconductor layer, growing the first semiconductor regions at selected portions, and forming the upper surface impurity diffusion suppressing layer at selected ares. The crystal growth suppression layer performs a plurality of roles throughout the entire process in the manufacturing method of the present invention. As a result, the number of steps in the manufacturing method of the present invention can be substantially reduced.

According to the present invention, it is possible to suppress the diffusion of p-type impurities into an adjoining semiconductor region by providing an impurity diffusion suppressing layer, and it is thus possible to prevent a deterioration of the characteristics of the semiconductor device. As a result, it is possible to perform adjustments, based on the pre-set impurity concentration, thickness, etc., so that the semiconductor device will have the desired characteristics. That is, by providing the impurity diffusion suppressing layer, it is possible to obtain a semiconductor device in which desired characteristics can easily be realized.

### Brief Description of the Drawings

The present invention can be better understood when read with reference to the following drawings. The compositional elements of the drawings do not necessarily have a fixed scale, but emphasize certain elements in order to display principles of the present invention. In the drawings, the same reference numbers refer to the same parts throughout differing drawings.
FIG. 1 shows a cross-sectional view of essential parts of a semiconductor device of a first embodiment.
FIG. 2 shows a manufacturing step (1) of the semiconductor device of the first embodiment.
FIG. 3 shows a manufacturing step (2) of the semiconductor device of the first embodiment.
FIG. 4 shows a manufacturing step (3) of the semiconductor device of the first embodiment.
FIG. 5 shows a manufacturing step (4) of the semiconductor device of the first embodiment.
FIG. 6 shows a manufacturing step (5) of the semiconductor device of the first embodiment.
FIG. 7 shows a manufacturing step (6) of the semiconductor device of the first embodiment.
FIG. 8 shows a manufacturing step (7) of the semiconductor device of the first embodiment.
FIG. 9 shows a manufacturing step (8) of the semiconductor device of the first embodiment.
FIG. 10 shows a cross-sectional view of the essential parts of a variant of the first embodiment.
FIG. 11 shows a manufacturing step (1) of the variant semiconductor device of the first embodiment.
FIG. 12 shows a manufacturing step (2) of the variant semiconductor device of the first embodiment.
FIG. 13 shows a manufacturing step (3) of the variant semiconductor device of the first embodiment.
FIG. 14 shows a manufacturing step (4) of the variant semiconductor device of the first embodiment.
FIG. 15 shows a manufacturing step (5) of the variant semiconductor device of the first embodiment.
FIG. 16 shows a manufacturing step (6) of the variant semiconductor device of the first embodiment.
FIG. 17 shows a manufacturing step (7) of the variant semiconductor device of the first embodiment.
FIG. 18 shows a cross-sectional view of the essential parts of another variant of the first embodiment.
FIG. 19 shows a cross-sectional view of the essential parts of another variant of the first embodiment.
FIG. 20 shows a manufacturing step (1) of the other variant semiconductor device of the first embodiment.
FIG. 21 shows a manufacturing step (2) of the other variant semiconductor device of the first embodiment.
FIG. 22 shows a manufacturing step (3) of the other variant semiconductor device of the first embodiment.
FIG. 23 shows a cross-sectional view of the essential parts of a semiconductor device of a second embodiment.
FIG. 24 shows a cross-sectional view of the essential parts of a variant of the second embodiment.
FIG. 25 shows a cross-sectional view of the essential parts of another variant of the second embodiment.

### Detailed Description of Preferred Embodiments

First, the features of the present invention will be listed below.
(First feature) The p-type impurities may be magnesium, beryllium, calcium, etc.
(Second feature) The diffusion coefficient of the p-type impurities in the impurity diffusion suppressing layer is smaller than the diffusion coefficient of the p-type impurities in the III-V compound semiconductors. The thickness of the impurity diffusion suppressing layer is adjusted based on the diffusion coefficient of the p-type impurities within a material forming the impurity diffusion suppressing layer. The impurity diffusion suppressing layer may be thin when the diffusion coefficient of the p-type impurities in the impurity diffusion suppressing layer is extremely small. The thickness of the impurity diffusion suppressing layer is preferably adjusted to a range greater than a diffusion length of the p-type impurities within the material forming the impurity diffusion suppressing layer.
(Third feature) The materials that work both as the impurity diffusion suppressing layer and the crystal growth suppression layer are silicon oxide, silicon nitride, etc. Embodiments will be described below with reference to the figures.

### (First embodiment)

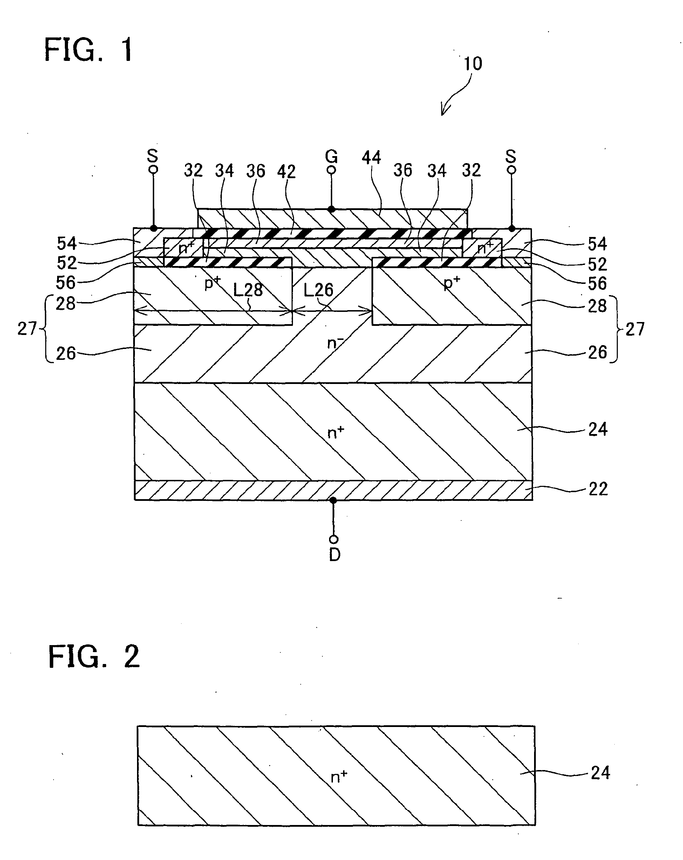

FIG. 1 is a cross-sectional view schematically showing the essential parts of a vertical type semiconductor device 10 that has a heterojunction. The cross-sectional view shown in FIG. 1 illustrates the essential parts of a unit configuration of the semiconductor device 10. In fact, this unit configuration is repeated along the left-right direction of the plane of the page.
A drain electrode 22 made of stacked layers of titanium (Ti) and aluminum (Al) is formed at a bottom surface of the semiconductor device 10. An n⁺ type drain layer 24 in which the main material is gallium nitride (GaN) is formed on the drain electrode 22. Silicon (Si) or oxygen (O) is utilized as the n type impurities in the drain layer 24, and carrier concentration thereof is adjusted so as to be approximately 3 x 10¹⁸cm⁻³.
An n⁻ type low concentration semiconductor region 26 in which the main material is gallium nitride is formed on the drain layer 24. Silicon is utilized as the impurities in the low concentration semiconductor region 26, and the carrier concentration thereof is adjusted so as to be approximately 1 x 10¹⁶cm⁻³.
P⁺ type first semiconductor regions 28 in which the main material is gallium nitride are formed on a plurality of portions of the low concentration semiconductor region 26. The first semiconductor regions 28 are distributed on the low concentration semiconductor region 26 such that a space is left between adjacent first semiconductor regions 28. Magnesium (Mg) is utilized as the p type impurities of the first semiconductor regions 28, and the carrier concentration thereof is adjusted so as to be approximately 1 x 10¹⁸cm⁻³. A plurality of the first semiconductor regions 28 is formed on the low concentration semiconductor region 26. The first semiconductor regions are distributed on the low concentration semiconductor region 26. A portion of the low concentration semiconductor region 26 is interposed at each interface between adjacent first semiconductor regions 28. A pair of first semiconductor regions 28 is separated by the low concentration semiconductor region 26.
The low concentration semiconductor region 26 and the first semiconductor regions 28 can be considered to form one semiconductor layer 27. In this case, a surface part of the semiconductor layer 27 is formed from the distributed first semiconductor regions 28, and the remaining part thereof is formed from the low concentration semiconductor region 26.
In this example, as shown in FIG. 1, two first semiconductor regions 28 are shown left-to-right across the page. When viewed from a plan view, the first semiconductor regions 28 extend toward the inner side with respect to the plane of the page. The first semiconductor regions 28 are disposed as a series of strips on an upper portion of the semiconductor layer 27. As will be described, the low concentration semiconductor region 26 interposed between the adjacent first semiconductor regions 28 is a region across which a current flows vertically. As a result, by forming the first semiconductor regions 28 in a distributed manner, the area of the low concentration semiconductor region 26 along which the current flows vertically is widely distributed within a plane along which the semiconductor layer 27 extends. As a result, the semiconductor device 10 is capable of achieving a low on-resistance.
The horizontal dimension L28 of each of the first semiconductor regions 28 is approximately 10 to 25 µm. FIG. 1 shows the unit configuration of the semiconductor device 10 whereas, in fact, this unit configuration is repeated along the left-right direction of the plane of the page. As a result, the actual horizontal dimension of each of the first semiconductor regions 28 is double the aforementioned dimension L28. A distance L26 between adjacent first semiconductor regions 28 is 1 to 10 µm.

Impurity diffusion suppression layer 32, in which the main material is silicon oxide (SiO₂), is formed on the first semiconductor regions 28. The impurity diffusion suppression layer 32 does not cover the entirety of each of the first semiconductor regions 28. As will be described later, a part of the surface of each of the first semiconductor regions 28 is not covered by the impurity diffusion suppression layer 32 so that each of the first semiconductor regions 28 and each of the source electrode 54 can make electrical contact.
A second semiconductor region 34, in which the main material is gallium nitride, is formed on the low concentration semiconductor region 26 and the impurity diffusion suppression layer 32. Silicon (Si) is utilized as the impurities in the second semiconductor region 34, and the carrier concentration thereof is adjusted so as to be approximately 1 x 10¹⁶cm⁻³.
A third semiconductor region 36 in which the main material is aluminum gallium nitride (Al_{0.3}Ga_{0.7}N) is formed on the second semiconductor region 34. Aluminum is included in the crystal structure of the third semiconductor region 36, and the band gap thereof is wider than the band gap of the second semiconductor region 34. A heterojunction is formed by the second semiconductor region 34 and the third semiconductor region 36. Silicon is utilized as the impurities in the third semiconductor region 36, and the carrier concentration thereof is adjusted so as to be approximately 1 x 10¹⁶cm⁻³.

A gate insulator layer 42, in which the main material is silicon oxide, is formed on the third semiconductor region 36. A gate electrode 44 in which the main material is nickel (Ni) is formed on the gate insulator layer 42. The gate electrode 44 of the present embodiment substantially faces the entirety of the second semiconductor region 34 and the third semiconductor region 36. However, as will be described later, the gate electrode 44 may be formed at least a part within a range facing the first semiconductor region 28. That is, as long as each of the gate electrodes 44 is formed within each region where the first semiconductor region 28, the impurity diffusion suppression layer 32, the second semiconductor region 34, and the third semiconductor region 36 are stacked, gate electrodes 44 selects between on and off states of the semiconductor device 10. The gate electrode 44 preferably faces the entirety of the second semiconductor region 34 and the third semiconductor region 36 that are present between a source region 52 and a central side edge of the first semiconductor region 28. On and off switching of the semiconductor device 10 can thus be performed accurately.
The n⁺ type source region 52 in which the main material is gallium nitride is formed so as to make contact with the second semiconductor region 34 and the third semiconductor region 36 (at left and right sides of the plane of the page). The source region 52 is formed in a position facing the first semiconductor region 28. The source region 52 is formed so as to not make contact with the second semiconductor region 34 in a range where the low concentration semiconductor region 26 interposed between the adjacent first semiconductor regions 28 adjoins the second semiconductor region 34 (the central part of the page). The source region 52 is formed so as to not make contact the third semiconductor region 36 in a range where the third semiconductor 36 faces the second semiconductor 34 in that range. In other words, in a horizontal direction, the source region 52 and the low concentration semiconductor region 26 located between the adjacent first semiconductor regions 28 are separated by the gate electrode 44 interposed therebetween. That is, a stacked structure consisting of the first semiconductor region 28, the impurity diffusion suppression layer 32, the second semiconductor region 34, the third semiconductor region 36, the gate insulator layer 42, and the gate electrode 44 is present between the source region 52 and the low concentration semiconductor region 26 located between the adjacent first semiconductor regions 28. Silicon is utilized as the impurities in the source region 52, and the carrier concentration thereof is adjusted so as to be approximately 3 x 10¹⁸cm⁻³.
The source electrode 54, which consists of stacked titanium and aluminum, is electrically connected to the source region 52 and the first semiconductor regions 28. A contact layer 56 is formed between the first semiconductor regions 28 and the source electrode 54. Nickel, for example, is utilized as the contact layer 56, and it is consequently possible to improve the ohmic contact between the first semiconductor regions 28 and the source electrode 54.

Next, the operation of the semiconductor device 10 will be described.

The first semiconductor regions 28 make contact indirectly with the second semiconductor region 34 via the impurity diffusion suppression layers 32. As a result, a depleted layer is formed in the second semiconductor region 34 when a voltage is not applied to the gate electrode 44, and this depleted layer extends to the heterojunction surface of the second semiconductor region 34 and the third semiconductor region 36. Consequently, the energy level of the conduction band of the heterojunction surface is thus at the upper side of the Fermi level. As a result, a two-dimensional electron gas layer is not formed at the heterojunction surface when the voltage is not applied to the gate electrode 44. The travel of electrons is consequently halted when the voltage is not applied to the gate electrode 44, and the semiconductor device 10 operates as a normally-off type.

The depleted layer formed in the second semiconductor region 34 contracts when a positive voltage is applied to the gate electrode 44, and the energy level of the conduction band of the heterojunction surface of the second semiconductor region 34 and the third semiconductor region 36 is thus reaches the lower side of the Fermi level. As a result, a two-dimensional electron gas layer is formed at the heterojunction surface. As a result, a state is created in which electrons are present in the potential well of the two-dimensional electron gas layer when the positive voltage is applied to the gate electrode 44. The electrons consequently travel along the two-dimensional electron gas layer, and the semiconductor device 10 is turned on. The electrons traveling horizontally from the source region 52 along the two-dimensional electron gas layer of the heterojunction surface flow vertically across the protruding portions of the low concentration semiconductor region 26 (these protruding portions are the parts that separate the adjacent first semiconductor regions 28, and are the parts making contact with the second semiconductor region 34), and flow across the low concentration semiconductor region 26 and the drain layer 24 to the drain electrode 22. Conduction thus occurs between the source electrode 54 and the drain electrode 22.

As described above, the on-off control of the semiconductor device 10 is performed at the part where the following are stacked: the first semiconductor region 28, the impurity diffusion suppression layer 32, the second semiconductor region 34, the third semiconductor region 36, the gate insulator layer 42, and the gate electrode 44. That is, the on-off control of the semiconductor device 10 is performed by controlling the thickness of the depleted layer formed in the second semiconductor region 34 by means of applying voltage to the gate electrode 44. The degree to which the depleted layer expands or contracts in the direction of thickness, based on the voltage applied to the gate electrode 44, greatly changes depending on the amount of carrier concentration of the second semiconductor region 34. If the carrier concentration of the second semiconductor region 34 is adjusted to a predetermined value, the on-off function of the semiconductor device 10 can be controlled by applying a predetermined gate voltage.

A case will be considered where the impurity diffusion suppression layers 32 are not provided. In this case, the large amount of the magnesium included in the first semiconductor regions 28 diffuses toward the second semiconductor region 34, reducing the effective carrier concentration of the silicon contained in the second semiconductor region 34. As a result, the gate voltage required to turn on the semiconductor device 10 (also termed the gate-on voltage required to form the two-dimensional electron gas layer) will become greater than the predetermined gate-on voltage. The threshold value of the semiconductor device 10 will be altered from the predetermined gate-on voltage. This makes it difficult to obtain a semiconductor device having the desired characteristics, and is a cause of reduced yield, etc.
However, the impurity diffusion suppression layer 32 is provided in the semiconductor device 10. The phenomenon, in which the magnesium included in the first semiconductor regions 28 diffuses toward the second semiconductor region 34, is suppressed by providing the impurity diffusion suppression layer 32. As a result, alteration of the threshold value of the semiconductor device 10 is prevented. It is consequently possible to obtain a semiconductor device 10 that realizes the desired threshold gate-on voltage, based on the pre-set carrier concentration, thickness, etc. of the second semiconductor region 34.

The present invention further comprises the following characteristics.
(1) In the manufacturing process (to be described), the silicon oxide layer or the silicon nitride layer of the impurity diffusion suppression layers 32 also functions as a mask for the ELO (Epitaxial Lateral Overgrowth) method. As a result, there is a reduction in the concentration of crystal defects in the second semiconductor region 34 and the third semiconductor region 36 that are formed above the impurity diffusion suppression layers 32. Since this portion forms the gate configuration, a reduction in the concentration of crystal defects also serves to control leaking current, etc. That is, providing the impurity diffusion suppression layers 32 not only controls the diffusion of impurities, but also effectively reduces the concentration of crystal defects, and is a technique that is of extreme utility.
(2) Since the first semiconductor regions 28 are electrically connected to the source electrode 54 via the contact layer 56, the potential of the first semiconductor regions 28 is stably fixed at a value equal to the earth potential. As a result, the depleted layer that is formed in the second semiconductor region 34 is formed stably when voltage is not applied to the gate electrode 44. The semiconductor device 10 can be reliably turned off when voltage is not applied to the gate electrode 44, and stable operation is thus realized.

### (Method of manufacturing the semiconductor device 10)

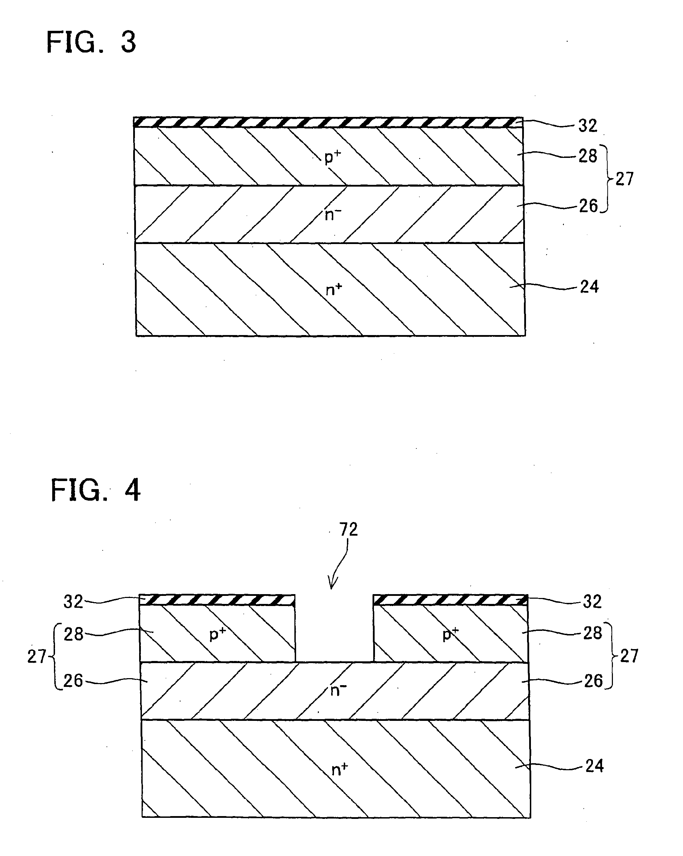

Next, the method of manufacturing the semiconductor device 10 will be described.
First, as shown in FIG. 2, the n⁺ type semiconductor substrate 24 (this later becomes the drain layer 24) in which the main material is gallium nitride is manufactured. The thickness of the semiconductor substrate 24 is approximately 200 µm.
Next, as shown in FIG. 3, the n⁻ type low concentration semiconductor region 26 is formed by growing crystal on the semiconductor substrate 24 using the MOCVD (Metal Organic Chemical Vapor Deposition) method. The thickness of the low concentration semiconductor region 26 is approximately 6 µm. Next, the p⁺ type first semiconductor region 28 is formed by growing crystal on the low concentration semiconductor region 26 using the MOCVD method. The thickness of the first semiconductor region 28 is approximately 1.0 µm. Next, the impurity diffusion suppression layer 32 is formed on the first semiconductor region 28 using the CVD (Chemical Vapor Deposition) method. The thickness of the impurity diffusion suppression layer 32 is approximately 0.01 µm.

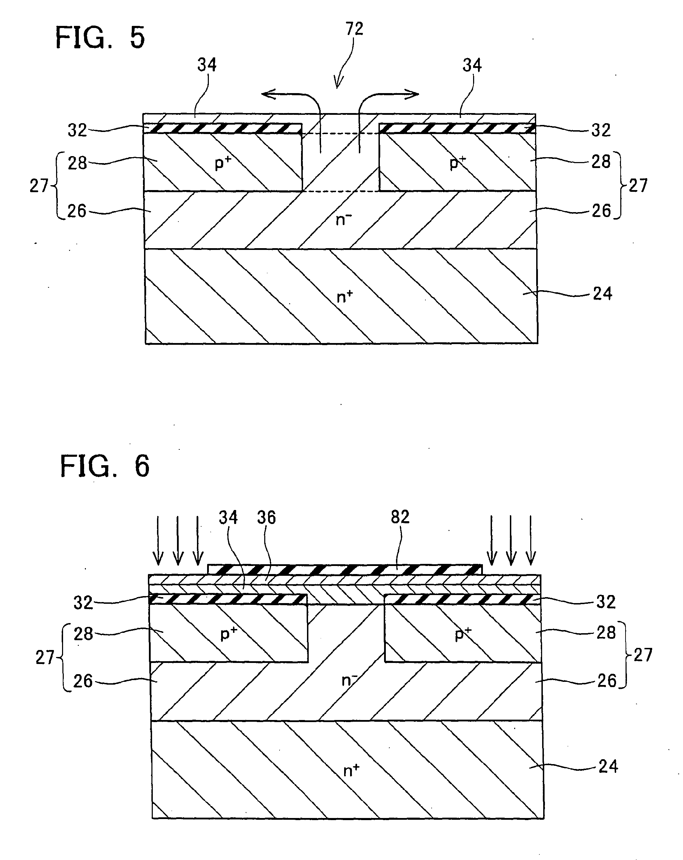

Next, as shown in FIG. 4, trenches 72 are formed by utilizing a lithography technique and the RIE technique, these trenches 72 extend down to the low concentration semiconductor region 26 through a part of the impurity diffusion suppression layers 32 and a part of the first semiconductor regions 28.
Next; as shown in FIG. 5, gallium nitride is formed by growing crystal on the surfaces of the low concentration semiconductor regions 26 exposed at bottoms the trenches 72 by utilizing the MOCVD method. The crystal growth continues until the surface of the impurity diffusion suppression layers 32 is covered by grown crystal. The amount of impurities in the crystal formed in this process is adjusted so as to be the same as the amount in the low concentration semiconductor region 26. As a result, the part where crystal growth has just occurred and the low concentration semiconductor region 26 can be considered to be one continuous region. At this juncture, the Epitaxial Lateral Overgrowth (ELO) technique is utilized in order to cover the surface of the impurity diffusion suppression layers 32. This part becomes a superior semiconductor layer in which the concentration of crystal defects is reduced. The thickness of the superior semiconductor layer stacked on the surface of the impurity diffusion suppression layers 32 is approximately 100 nm. Furthermore, in a case where the superior semiconductor layer grown by the ELO technique is too thick, etching, grinding, etc. can be utilized in order to adjust this layer to the desired thickness. Moreover, although the part where crystal growth has occurred can be judged as essentially one region, the upper section where crystal growth occurred will be distinguished in the description below as the second semiconductor region 34 so that it can be correlated with the semiconductor device 10 shown in FIG. 1.

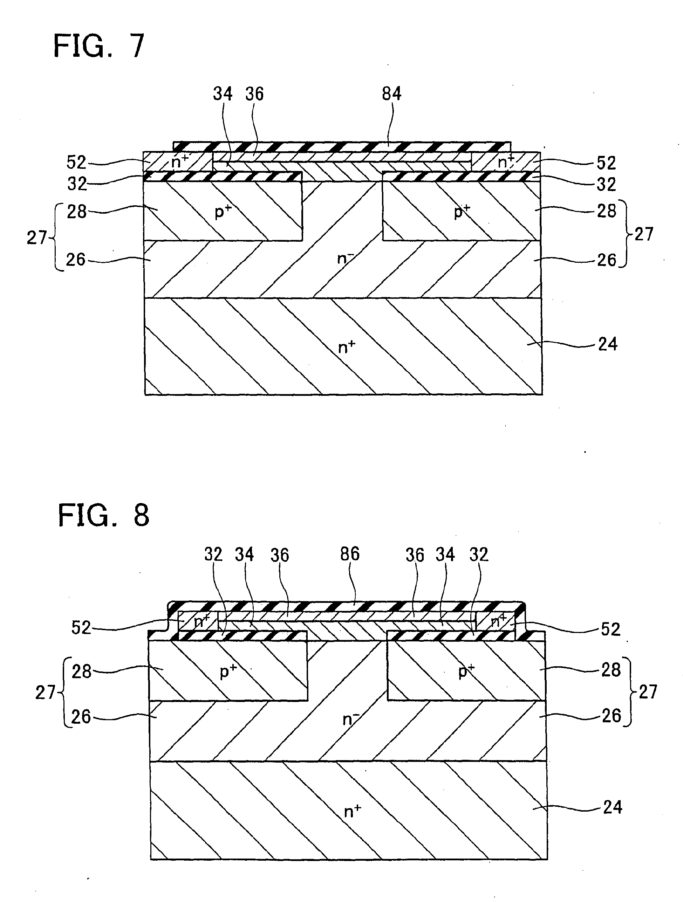

Next, as shown in FIG. 6, the third semiconductor region 36 is formed by growing crystal on the second semiconductor region 34 using the MOCVD method. The thickness of the third semiconductor region 36 is approximately 50 nm.
Then, a layer of silicon oxide is formed on the surface of the third semiconductor region 36 using the CVD method, to form a first mask 82. The first mask 82 is used, by utilizing a lithography technique and an etching technique, to remove a part corresponding to the source region 52 that is to be constructed.
Next, ion implantation is performed to form the source region 52. At this juncture, silicon is implanted at a dose amount of 1 x 10¹⁵cm⁻², and at an acceleration voltage of 35eV. Then the first mask 82 is removed, and the entire surface is covered with a silicon oxide second mask layer 84 (not shown in FIG. 6, see FIG. 7). After the second mask layer 84 has been formed, an annealing process is performed (N₂ atmosphere, 1300°C, 5 minutes).
Next, as shown in FIG. 7, a section of the second mask 84 is removed by utilizing the lithography technique and the etching technique, thus exposing the source region 52.
Next, the RIE method is utilized to form trenches extending from the exposed source region 52 to the impurity diffusion suppression layers 32. Then a HF aqueous solution is utilized to remove the silicon oxide second mask layer 84 and the exposed impurity diffusion suppression layers 32. Then, as shown in FIG. 8, a sputtering method is utilized to deposit a silicon oxide layer 86 across the entire surface. The thickness of the silicon oxide layer 86 is approximately 50 nm.

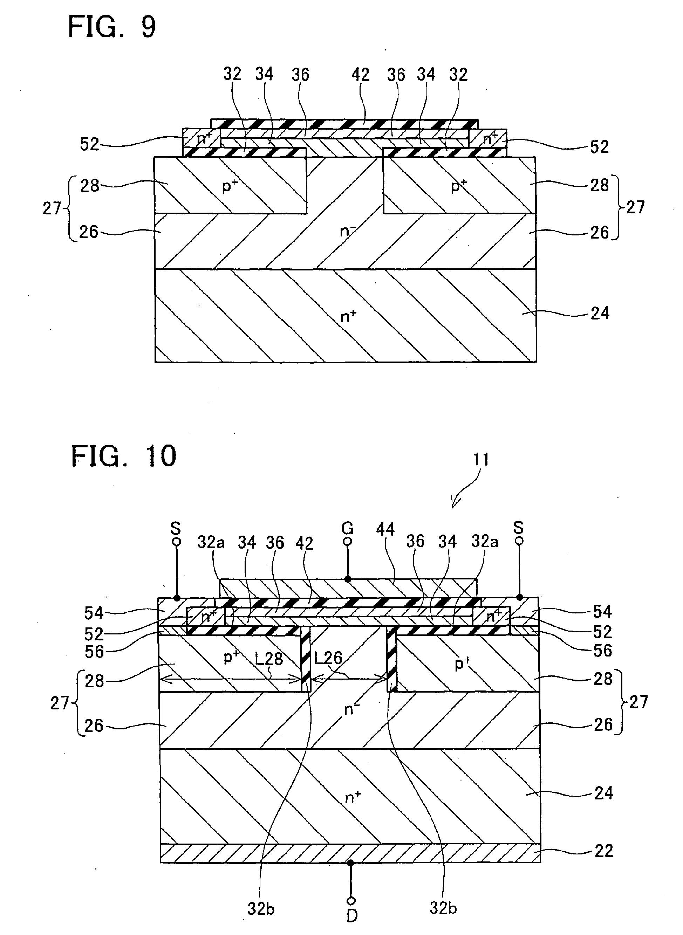

Next, as shown in FIG. 9, a part of the silicon oxide layer 86 is removed, and the remaining part forms the gate insulator layer 42.
Then, the sputtering method is utilized to deposit the contact layer 56 on the surface of the first semiconductor regions 28 that were exposed as a result of the aforementioned removal. Next, the sputtering method is utilized to deposit the source electrode 54 on the surface of the contact layer 56 and the source region 52. The drain electrode 22 is also formed utilizing the sputtering method on a bottom surface of the drain layer 24.
Next, a sintering process is performed in an N₂ atmosphere, at 500°C for 2 minutes. Finally, the gate electrode 44, in which the main material is nickel, is formed by a lift-off method.
The semiconductor device 10 shown in FIG. 1 can be obtained by performing these steps.

### (Variant 1 of the Semiconductor Device 10)

FIG. 10 schematically shows a cross-sectional view of the essential parts of a semiconductor device 11 that is a first variant of the semiconductor device 10. Configurational elements that are essentially the same as those of the semiconductor device 10 have the same reference numbers applied thereto, and an explanation thereof is omitted.
The semiconductor device 11 comprises a side surface impurity diffusion suppression layer 32b. The side surface impurity diffusion suppression layer 32b is formed between the first semiconductor region 28 and the low concentration semiconductor region 26 that is interposed between the adjacent first semiconductor regions 28. The side surface impurity diffusion suppression layer 32b makes contact with the low concentration semiconductor region 26 that separates the adjacent first semiconductor regions 28. The side surface impurity diffusion suppression layer 32b is formed on both sides of the portion where the low concentration semiconductor region 26 makes contact with the second semiconductor region 34 (also referred to as the portion where the low concentration semiconductor region 26 separates the adjacent first semiconductor regions 28). The protruding low concentration semiconductor region 26 and the first semiconductor regions 28 are separated by the side surface impurity diffusion suppression layers 32b. Here, the impurity diffusion suppression layer formed on the upper surface of the first semiconductor regions 28 will be termed an upper surface impurity diffusion suppression layer 32a, thus distinguishing it from the side surface impurity diffusion suppression layer 32b.
The low concentration semiconductor region 26 located between the adjacent first semiconductor regions 28 is a path along which current flows vertically when the semiconductor device 11 is turned on. As a result, the effective carrier concentration in this part exerts a strong effect on the on-resistance of the semiconductor device 11. For example, when the magnesium from the first semiconductor regions 28 diffuses into the aforementioned part, thus reducing the effective carrier concentration in this part, the on-resistance of the semiconductor device 11 is increased. Furthermore, when the magnesium from the first semiconductor regions 28 diffuses into the aforementioned part, the effective space separating the first semiconductor regions 28 becomes narrower. In this case, also, the on-resistance of the semiconductor device 11 is increased. If the side surface impurity diffusion suppression layers 32b are not provided, the magnesium from the first semiconductor regions 28 would diffuse into the low concentration semiconductor region 26 located between the adjacent first semiconductor regions 28. In order to avoid the effects of magnesium diffusion, it is necessary to ensure that the distance L26 between the adjacent first semiconductor regions 28 remains large. However, if the distance L26 is large, a phenomenon occurs in which the depleted layer that extends from the junction surface of the first semiconductor region 28 and the low concentration semiconductor region 26 is not capable of depleting the entirety of the low concentration semiconductor region 26 between the adjacent first semiconductor regions 28. In this case, the high voltage between the source electrode 54 and the drain electrode 22 is applied to the gate insulator layer 42, and breakdown of the gate insulator layer 42 occurs. As a result, in a case where the side surface impurity diffusion suppression layers 32b are not provided, it is difficult to suppress the breakdown of the gate insulator layer 42 while maintaining a small on-voltage for the semiconductor device 11.
On the other hand, when the side surface impurity diffusion suppression layers 32b are provided, as shown in FIG. 10, it is possible to suppress the diffusion of magnesium from the first semiconductor regions 28 into the low concentration semiconductor region 26 located between the adjacent first semiconductor regions 28. It is consequently unnecessary for the distance L26 between the adjacent first semiconductor regions 28 to remain large. Even if the distance L26 is not large, the effective carrier concentration of the low concentration semiconductor region 26 located between the adjacent first semiconductor regions 28 can be maintained. Furthermore, since the diffusion of magnesium can be suppressed, it is also possible to suppress changes in the effective space of the low concentration semiconductor region 26. When the side surface impurity diffusion suppression layers 32b are provided, it is possible to suppress the breakdown of the gate insulator layer 42 while maintaining a small on-voltage for the semiconductor device 11.

### (Method of manufacturing the semiconductor device 11)

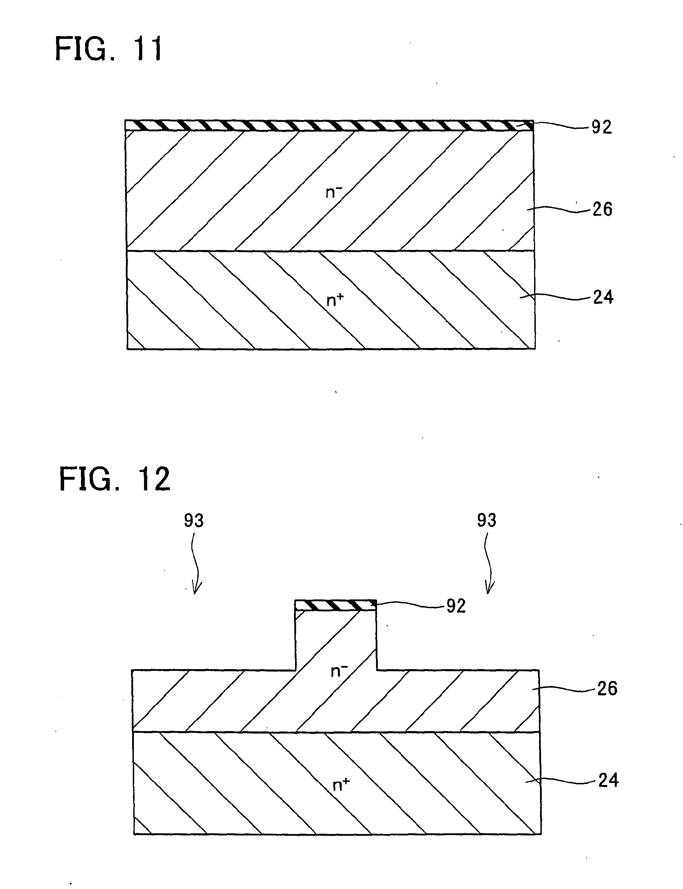

Next, the method of manufacturing the semiconductor device 11 will be described.
First, a stacked structure as shown in FIG. 11 is prepared. This stacked structure can be formed in the sequence described below. First, the n⁻ type low concentration semiconductor region 26 is formed by growing crystal using the MOCVD (Metal Organic Chemical Vapor Deposition) method on the n⁺ type drain layer 24 in which the main material is gallium nitride. Then, by utilizing the CVD (Chemical Vapor Deposition) method, the silicon oxide processing mask 92 (an example of a crystal growth suppression layer 92) is formed on the low concentration semiconductor region 26 and the stacked structure is obtained. The thickness of the drain layer 24 is approximately 200 µm. The thickness of the low concentration semiconductor region 26 is approximately 7 µm.

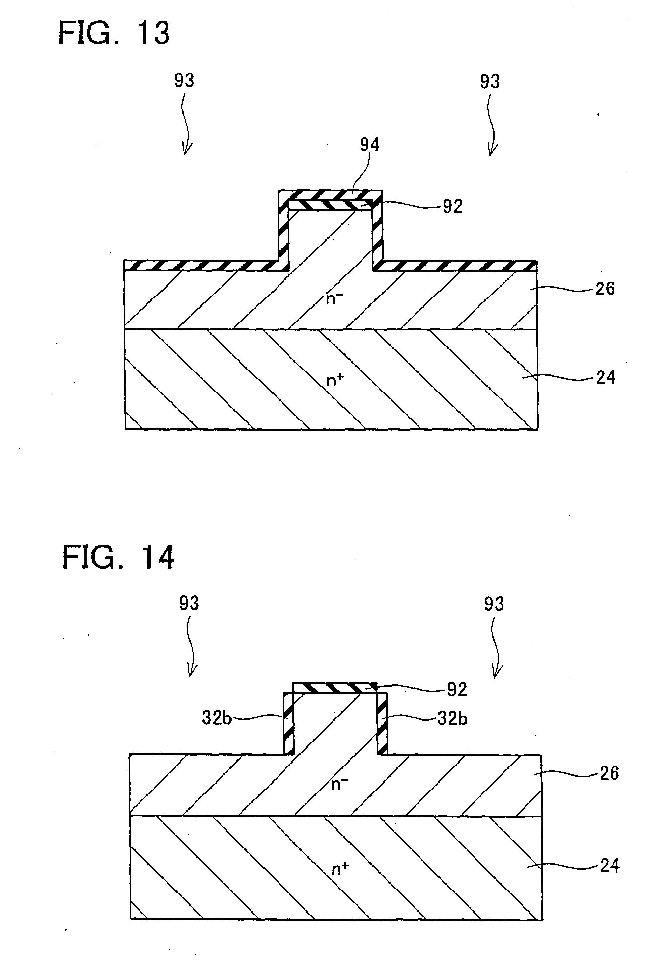

Next, as shown in FIG. 12, the processing mask 92 is patterned by utilizing a lithography technique. Then, the surface of the low concentration semiconductor region 26 is etched, by utilizing the RIE method, with the parts of the low concentration semiconductor region 26 that are not covered by the processing mask 92 being removed, thus forming a plurality of trenches 93 in the upper part of the low concentration semiconductor region 26. The depth of the trenches 93 is approximately 1 µm.
Then, as shown in FIG. 13, the low temperature MOCVD method is utilized to form an aluminum nitride layer 94 on the bottom surface and side surfaces of the trenches 93 and on the upper surface of the processing mask 92. At this juncture, the crystal growth temperature of the low temperature MOCVD method is controlled so as to be 350 ~ 450°C. When the crystal growth temperature is controlled to within this temperature range, the aluminum nitride layer 94 is formed on the bottom surface and the side surfaces of the trenches 93 (i.e. on the exposed surface of the low concentration semiconductor region 26), and on the upper surface of the processing mask 92. If the temperature is above the aforementioned crystal growth temperature range, the aluminum nitride layer 94 is formed only on the bottom surface and side surfaces of the trenches 93 and is not formed on the upper surface of the processing mask 92. If needed, this step can also be performed utilizing the high temperature MOCVD method.

Next, as shown in FIG. 14, an anisotropic etching technique is utilized to remove the aluminum nitride layer 94 formed on the bottom surface of the trenches 93 and the upper surface of the processing mask 92, so that the aluminum nitride layer 94 remains only on the side surfaces of the trenches 93. The remaining aluminum nitride layer 94 forms the side surface impurity diffusion suppression layers 32b. The RIE method, the ICP method, etc. are utilized in the anisotropic etching technique.

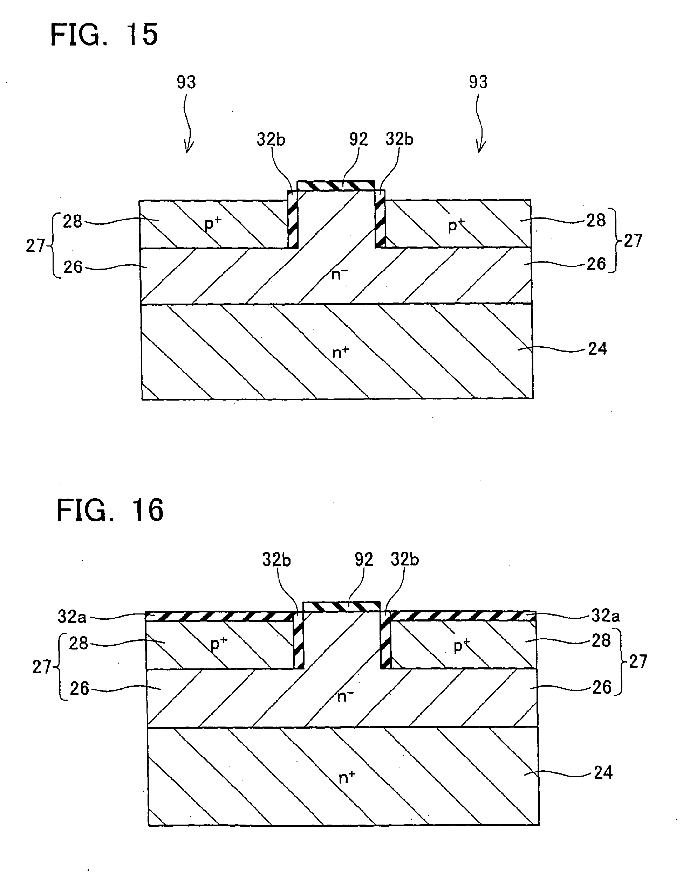

Next, as shown in FIG. 15, the first semiconductor regions 28 that include p-type impurities are formed by growing crystal, utilizing the MOCVD method, from the upper surfaces of the low concentration semiconductor region 26 that are exposed at the bottoms of the trenches 93. At this juncture, the processing mask 92 covers the top surface of the protruding low concentration semiconductor region 26. As a result, selective crystal growth of the first semiconductor regions 28 can be performed only within the trenches 93.
Next, as shown in FIG. 16, the upper surface impurity diffusion suppression layer 32a is formed on the upper surfaces of the first semiconductor regions 28 utilizing the high temperature MOCVD method. At this juncture, the crystal growth temperature of the high temperature MOCVD method is controlled to be within the temperature range 1050 ~ 1250°C. When the crystal growth temperature is controlled to within this temperature range, the upper surface impurity diffusion suppression layer 32a is formed only on the upper surface of the first semiconductor regions 28, and is not formed on the upper surface of the processing mask 92.

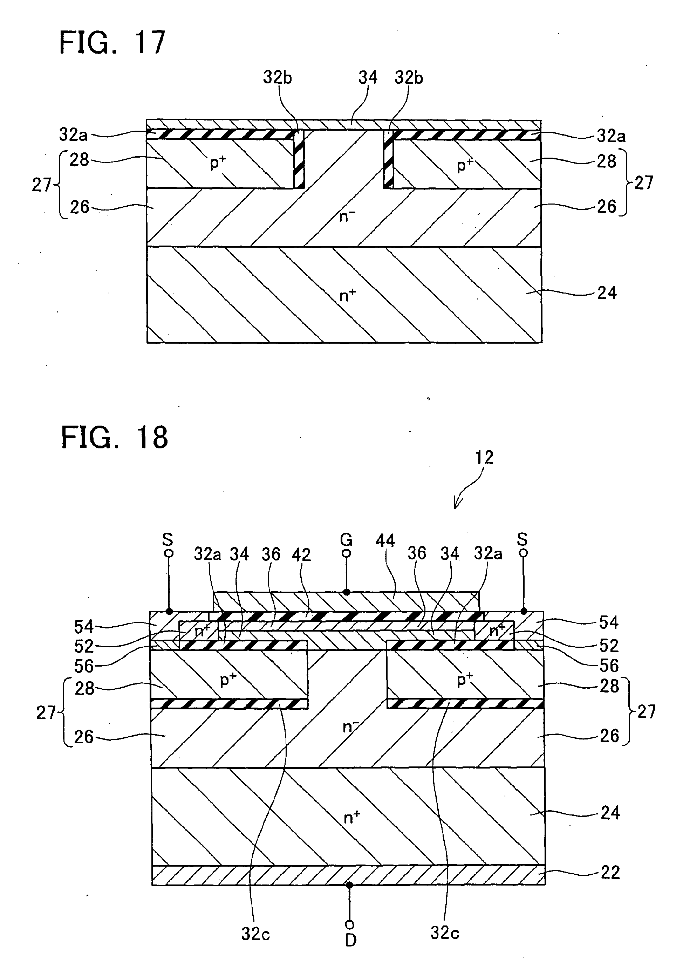

Next, as shown in FIG. 17, the processing mask 92 is selectively removed and then the gallium nitride second semiconductor region 34 is formed by growing crystal, utilizing the MOCVD method, from the upper surface of the impurity diffusion suppression layer 32a and the low concentration semiconductor region 26. The thickness of the second semiconductor region 34 is 100 nm.
The remaining steps of the manufacturing process can be completed utilizing the same methods as the manufacturing methods of the semiconductor device 10. The semiconductor device 11 shown in FIG. 10 can be obtained by performing these steps.

### (Variant 2 of the Semiconductor Device 10)

FIG. 18 schematically shows a cross-sectional view of the essential parts of a semiconductor device 12 that is a second variant of the semiconductor device 10. Configurational elements that are essentially the same as those of the semiconductor device 10 have the same reference numbers applied thereto, and an explanation thereof is omitted.
The semiconductor device 12 comprises a bottom surface impurity diffusion suppression layer 32c. The bottom surface impurity diffusion suppression layer 32c is formed between the bottom surface of the first semiconductor regions 28 and the low concentration semiconductor region 26. The bottom surface impurity diffusion suppression layer 32c suppresses the diffusion of magnesium from the first semiconductor regions 28 into the low concentration semiconductor region 26 that is located below the first semiconductor regions 28.
In the semiconductor device 12, the source electrode 54 and the drain electrode 22 are arranged in the vertical direction. As a result, the voltage between the source electrode 54 and the drain electrode 22 must be applied in the vertical direction of the semiconductor device 12. This vertical voltage is chiefly applied across by the low concentration semiconductor region 26. If the bottom surface impurity diffusion suppression layers 32c are not provided, magnesium from the first semiconductor regions 28 diffuses into the low concentration semiconductor region 26 located below the first semiconductor regions 28. As a result the effective carrier concentration of the low concentration semiconductor region 26 changes and the depleted layer that extends from the junction surface of the first semiconductor regions 28 and the low concentration semiconductor region 26 is no longer capable of depleting across the broad thickness of the low concentration semiconductor region 26. The vertical voltage bearing ability of the semiconductor device 12 consequently falls, and the breakdown voltage of the semiconductor device 12 falls.
On the other hand, when the bottom surface impurity diffusion suppression layer 32c is provided, it is possible to suppress the diffusion of the magnesium from the first semiconductor regions 28 into the low concentration semiconductor region 26 located below the first semiconductor regions 28. As a result, the depleted layer extending from the junction surface indirectly making contact with the first semiconductor regions 28 and the low concentration semiconductor region 26 is capable of depleting across the broad thickness of the low concentration semiconductor region 26. The breakdown voltage of the semiconductor device 12 can consequently be maintained at an appropriately high level.

### (Variant 3 of the Semiconductor Device 10)

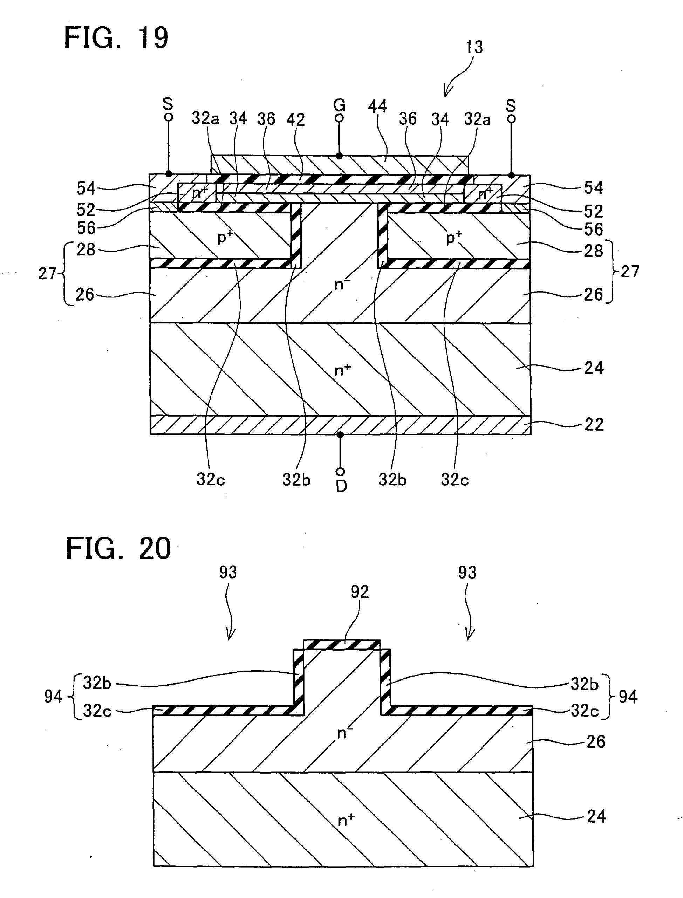

FIG. 19 schematically shows a cross-sectional view of the essential parts of a semiconductor device 13 that is a third variant of the semiconductor device 10. Configurational elements that are essentially the same as those of the semiconductor device 10 have the same reference numbers applied thereto, and an explanation thereof is omitted.
The semiconductor device 13 comprises both side surface impurity diffusion suppression layers 32b and bottom surface impurity diffusion suppression layer 32c. In the semiconductor device 13, the first semiconductor regions 28 and the low concentration semiconductor region 26 are completely separated by the side surface impurity diffusion suppression layers 32b and the bottom surface impurity diffusion suppression layer 32c. Diffusion of the magnesium included in the first semiconductor regions 28 into any regions of the low concentration semiconductor region 26 is consequently suppressed in the semiconductor device 13.
The operation and effects of both the semiconductor device 11 and the semiconductor device 12 can be realized simultaneously in the case of the semiconductor device 13. As a result, it is possible to realize both low on-voltage and high breakdown voltage characteristics in the semiconductor device 13. Furthermore, the operation of the parasitic pn diode created by the first semiconductor regions 28 and the low concentration semiconductor region 26 is also suppressed. The operation of the semiconductor device 13 is extremely stable.

### (Method of manufacturing the semiconductor device 13)

Next, the method of manufacturing the semiconductor device 13 will be described. The method of manufacturing the semiconductor device 13 is the same as the method of manufacturing the semiconductor device 11 until the step shown in FIG. 12.
Next, as shown in FIG. 20, the high temperature MOCVD method is utilized to form an aluminum nitride layer 94 on the bottom surfaces and side surfaces of the trenches 93. At this juncture, the crystal growth temperature of the high temperature MOCVD method is controlled to within a temperature range of 1050 ~ 1250°C. When the crystal growth temperature is controlled to within this temperature range, the aluminum nitride layer 94 is formed only on the bottom surfaces and side surfaces of the trenches 93 (i.e. on the surfaces of the exposed low concentration semiconductor region 26), and is not formed on the upper surface of the processing mask 92. In the description below, the part of aluminum nitride layer 94 that has formed on the bottom surfaces of the trenches 93 is termed the bottom surface impurity diffusion suppression layer 32c, and the part thereof that has formed on the side surfaces is termed the side surface impurity diffusion suppression layer 32b.

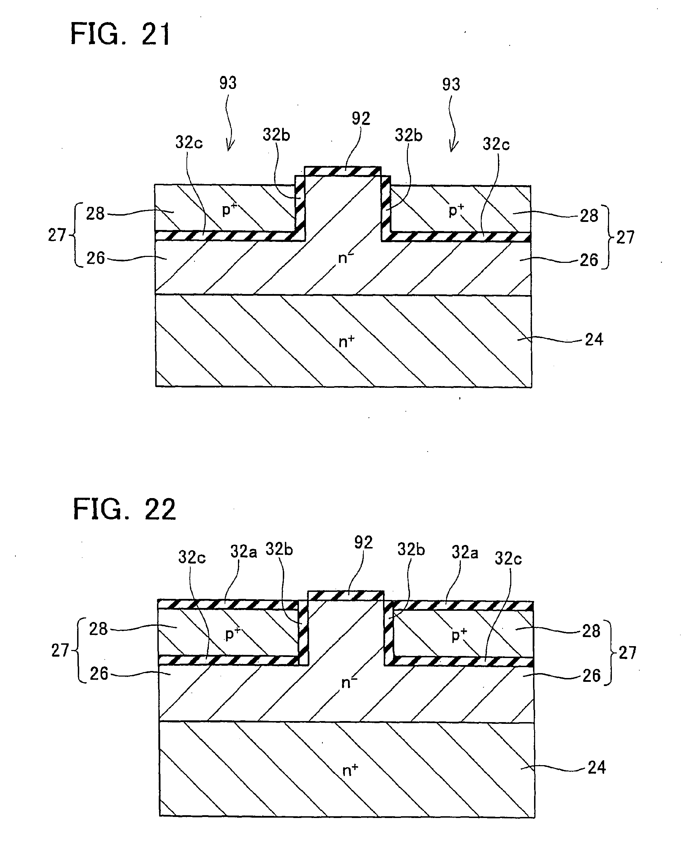

Next, as shown in FIG. 21, the first semiconductor regions 28 that include p-type impurities are formed by growing crystal, utilizing the MOCVD method, from the upper surface of the bottom surface impurity diffusion suppression layer 32c. At this juncture, the processing mask 92 covers the top surfaces of the protruding portions of the low concentration semiconductor region 26. As a result, selective crystal growth of the first semiconductor regions 28 can be performed only within the trenches 93.
Next, as shown in FIG. 22, the upper surface impurity diffusion suppression layers 32a are formed on the upper surface of the first semiconductor regions 28 by utilizing the high temperature MOCVD method. At this juncture, the crystal growth temperature of the high temperature MOCVD method is controlled to within the temperature range 1050 ~ 1250°C. When the crystal growth temperature is controlled to within this temperature range, the upper surface impurity diffusion suppression layer 32a is formed only on the upper surfaces of the first semiconductor regions 28, and is not formed on the upper surface of the processing mask 92.
The remaining steps of the manufacturing process can be completed utilizing the same methods as the manufacturing methods of the semiconductor device 10 and the semiconductor device 11. The semiconductor device 13 shown in FIG. 19 can be obtained by performing these steps.

### (Second Embodiment)

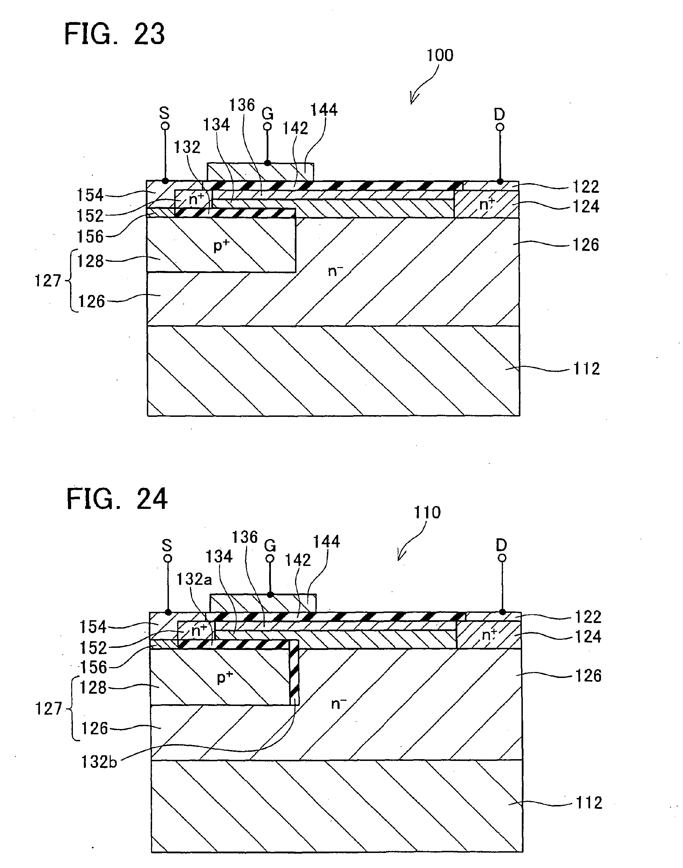

FIG. 23 is a cross-sectional view schematically showing the essential parts of a planer type semiconductor device 100 that has a heteroj unction.
The semiconductor device 100 comprises a substrate 112 in which the main material is sapphire (Al₂O₃). An n⁻ type low concentration semiconductor region 126, in which the main material is gallium nitride, is formed on the substrate 112.
P⁺ type first semiconductor regions 128 are formed on a plurality of portions of the low concentration semiconductor region 126. Magnesium (Mg) is utilized as the impurity in the first semiconductor regions 128.
The low concentration semiconductor region 126 and the first semiconductor regions 128 can be considered to form one semiconductor layer 127. In this case, the first semiconductor regions 128 are formed in an upper section of the semiconductor layer 127, and the remaining part thereof is the low concentration semiconductor region 126.

An impurity diffusion suppression layer 132, in which the main material is silicon oxide, is formed on the first semiconductor regions 128. The impurity diffusion suppression layer 132 does not cover the entirety of each of the first semiconductor regions 128. As will be described later, a part of the surface of each of the first semiconductor regions 128 is not covered by the impurity diffusion suppression layer 132 so that each of the first semiconductor regions 128 and each of source electrodes 154 make electrical contact.
A second semiconductor region 134 in which the main material is gallium nitride is formed on the low concentration semiconductor region 126 and the impurity diffusion suppression layer 132. Silicon is utilized as the impurities in the second semiconductor region 134.
A third semiconductor region 136, in which the main material is aluminum gallium nitride (Al_{0.3}Ga_{0.7}N), is formed on the second semiconductor region 134. Aluminum is included in the crystal structure of the third semiconductor region 136, and the band gap thereof is wider than the band gap of the second semiconductor region 134. A heterojunction is formed by the second semiconductor region 134 and the third semiconductor region 136. Silicon is utilized as the impurities for the third semiconductor region 136.

A gate insulator layer 142, in which the main material is silicon oxide, is formed on the third semiconductor region 136. A gate electrode 144, in which the main material is nickel, is formed on the gate insulator layer 142. The gate electrode 144 may be formed so that at least a part of each of the gate electrodes 144 faces each of the first semiconductor regions 128. That is, at least a part of each of the gate electrodes 144 is formed where the first semiconductor region 128, the impurity diffusion suppression layer 132, the second semiconductor region 134, and the third semiconductor region 136 are stacked. The gate electrode 144 preferably faces the entirety of the second semiconductor region 134 and the third semiconductor region 136 that are present between a source region 152 and right side edge of the first semiconductor region 128. On and off switching of the semiconductor device 100 can thus be performed accurately.
The n⁺ type source region 152, in which the main material is gallium nitride, is formed so as to make contact with the second semiconductor region 134 and the third semiconductor region 136. The source region 152 is formed in a position facing the first semiconductor region 128 (at the left side of the page). The source region 152 is formed so as to not make contact with the second semiconductor region 134 in the section where the low concentration semiconductor region 126 makes contact with the second semiconductor region 134 (the right side of the page). The source region 152 is also formed so as to not make contact with the third semiconductor region 136 where the third semiconductor region faces the section in which the second semiconductor region 134 makes contact with the low concentration region 126. In other words, the section where the low concentration semiconductor region 126 makes contact with the second semiconductor region 134 (the right side of the page) and the section where the second semiconductor region 134 makes contact with the source region 152 (the left side of the page) are separated by the section that is located below the gate electrode 144. That is, a stacked structure consisting of the first semiconductor region 128, the impurity diffusion suppression layer 132, the second semiconductor region 134, the third semiconductor region 136, the gate insulator layer 142, and the gate electrode 144 is present between the source region 152 and the section where the low concentration semiconductor region 126 makes contact with the second semiconductor region 134 (the right side of the page). Silicon is utilized as the impurities in the source region 152.

The source electrode 154, which consists of stacked titanium and aluminum, is electrically connected to the source region 152 and the first semiconductor regions 128. A contact layer 156 is formed between the first semiconductor region 128 and the source electrode 154. Nickel, for example, is utilized as the contact layer 156, and it is thus possible to improve the ohmic contact between the first semiconductor region 128 and the source electrode 154.
An n⁺ type drain region 124, in which the main material is gallium nitride, is formed so as to make contact with the second semiconductor region 134 and the third semiconductor region 136 in a section that is not facing the first semiconductor region 128 (the right side of the page). Silicon is utilized as the impurities in the drain region 124. A drain electrode 122, which consists of stacked titanium and aluminum, makes contact with the drain region 124.
The following stacked structure is interposed between the source region 152 and the drain region 124: wherein the first semiconductor region 128, the impurity diffusion suppression layer 132, the second semiconductor region 134, the third semiconductor region 136, the gate insulator layer 142, and the gate electrode 144 are stacked within the stacked structure. The gate electrode 144 is disposed between the source electrode 154 and the drain electrode 122.

Next, the operation of the semiconductor device 100 will be described.
The first semiconductor region 128 indirectly make contact with the second semiconductor region 134 via the impurity diffusion suppression layer 132. As a result, a depleted layer is formed in the second semiconductor region 134 when a voltage is not applied to the gate electrode 144, and this depleted layer extends to the heterojunction surface between the second semiconductor region 134 and the third semiconductor region 136. Consequently, the energy level of the conduction band of the heterojunction surface is thus at the upper side of the Fermi level. As a result, a two-dimensional electron gas layer is not formed at the heterojunction surface when the voltage is not applied to the gate electrode 144. The travel of electrons is consequently halted when the voltage is not being applied to the gate electrode 144, and the semiconductor device 100 operates as a normally-off type.

The depleted layer formed in the second semiconductor region 134 contracts when a positive voltage is applied to the gate electrode 144, and a two-dimensional electron gas layer is formed at the heterojunction surface between the second semiconductor region 134 and the third semiconductor region 136. Consequently, the energy level of the conduction band of the two-dimensional electron gas layer is thus at the lower side of the Fermi level. As a result, a state is created in which electrons are present in the potential well of the two-dimensional electron gas layer when the positive voltage is applied to the gate electrode 144. The electrons consequently travel along the two-dimensional electron gas layer, and the semiconductor device 100 is turned on. The electrons travel horizontally from the source region 152 to the drain region 124 along the two-dimensional electron gas layer formed at the heterojunction surface, and conduction thus occurs between the source electrode 154 and the drain electrode 122.

In this case, as with the first embodiment, the phenomenon, in which the magnesium included in the first semiconductor region 128 diffuses into the second semiconductor region 134, is suppressed by providing the impurity diffusion suppression layers 132. As a result, alteration of the threshold value of the semiconductor device 100 is prevented. Consequently, it is possible to obtain a semiconductor device 100 that realizes the desired threshold value based on the pre-set carrier concentration, thickness, etc. of the second semiconductor region 134.
Furthermore, providing the impurity diffusion suppression layers 132 not only suppresses the diffusion of impurities, but also realizes a reduction in the concentration of crystal defects in the gate configuration.
Furthermore, since the first semiconductor region 128 is electrically connected to the source electrode 154 via the contact layer 156, the potential of the first semiconductor regions 128 is stably fixed at the earth potential. As a result, the depleted layer formed in the second semiconductor region 134, when voltage is not being applied to the gate electrode 144, is formed stably and the operation of the semiconductor device 100 is thus stabilized.

### (Variant of the Semiconductor Device 100)

FIG. 24 schematically shows a cross-sectional view of the essential parts of a semiconductor device 110 that is a variant of the semiconductor device 100. Configurational elements that are essentially the same as those of the semiconductor device 100 have the same reference numbers applied thereto, and an explanation thereof is omitted.
The semiconductor device 110 is characterized by the fact that it comprises a side surface impurity diffusion suppression layer 132b. The side surface impurity diffusion suppression layer 132b is formed between the side surface of the first semiconductor region 128 and the low concentration semiconductor region 126. The side surface impurity diffusion suppression layers 132b suppress the diffusion of magnesium from the first semiconductor regions 128 into the low concentration semiconductor region 126 located laterally with respect to the first semiconductor regions 128.
In the semiconductor device 110, the source electrode 154 and the drain electrode 122 are arranged in the horizontal direction. As a result, the voltage between the source electrode 154 and the drain electrode 122 must be applied across the horizontal direction of the semiconductor device 110. This horizontal voltage is chiefly applied across the low concentration semiconductor region 126. If the side surface impurity diffusion suppression layers 132b are not provided, the magnesium from the first semiconductor regions 128 diffuses into the low concentration semiconductor region 126 located laterally with respect to the first semiconductor regions 128. As a result, the effective distance from the pn junction to the drain region 124 decreases, with this pn junction being formed by the first semiconductor region 128 and the low concentration semiconductor region 126. Since the voltage between the source electrode 154 and the drain electrode 122 is applied between the pn junction and the drain region 124, there is a decrease in the performance of bearing horizontal voltage in this semiconductor device 110, and the breakdown voltage of the semiconductor device 110 decreases.
On the other hand, when the side surface impurity diffusion suppression layers 132b are provided, it is possible to suppress the diffusion of the magnesium from the first semiconductor regions 128 into the low concentration semiconductor region 126 located laterally with respect to the first semiconductor regions 128. As a result, the effective distance from the pn junction to the drain region 124 is maintained at an appropriate value, and the breakdown voltage of the semiconductor device 110 can be maintained at an appropriately high level.

### (Another Variant of the Semiconductor Device 100)

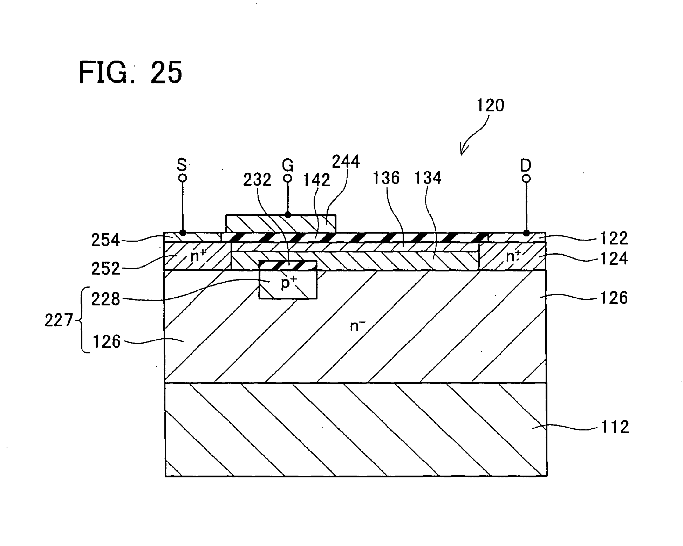

FIG. 25 schematically shows a cross-sectional view of the essential parts of a semiconductor device 120 that is another variant of the semiconductor device 100. Configurational elements that are essentially the same as those of the semiconductor device 100 have the same reference numbers applied thereto, and an explanation thereof is omitted.
In the semiconductor device 120, first semiconductor regions 228 are island-shaped and are formed within the semiconductor layer 227. Each of gate electrodes 244 extends across the horizontal range of each of the first semiconductor regions 228, and is formed on a gate insulator layer 142.
In this variant it is easy to form the required distance between the source electrode 254 and the gate electrode 244. As a result, it is possible to suppress current leakage, etc. between the two.

Specific examples of the present invention are described above in detail, but these examples are merely illustrative and place no limitation on the scope of the patent claims. The technology described in the patent claims also encompasses various changes and modifications to the specific examples described above.
Examples were shown in the above embodiments in which the heterojunction was formed by the second semiconductor region and the third semiconductor region. The technology of the present invention also has utility in a type of semiconductor device where the third semiconductor region is not present, and electrons travel within the second semiconductor region. In this case, it is preferred that the second semiconductor region includes n-type impurities. The travel of the electrons within the second semiconductor region is controlled by the voltage applied to the gate electrode. Since the impurity diffusion suppression layer is interposed between the first semiconductor regions and the second semiconductor region, diffusion of the p-type impurities, included in the first semiconductor regions, into the second semiconductor region is suppressed. It is consequently possible, based on pre-set impurity concentration and thickness, etc. of the second semiconductor region, to adjust the magnitude of the threshold values such that they are the desired values.
Furthermore, the technical elements explained in the present specification and drawings provide technical value and utility either independently or through various combinations. The present invention is not limited to the combinations described at the time the claims are filed. Additionally, the purpose of the examples illustrated by the present specification and drawings is to satisfy multiple objectives simultaneously, and satisfying any one of those objectives gives technical value and utility to the present invention.

## Claims

1. A semiconductor device comprising:
a first semiconductor region of a III-V compound semiconductor including p-type impurities;
a second semiconductor region of a III-V compound semiconductor; and
an impurity diffusion suppression layer interposed between the first semiconductor region and the second semiconductor region.

2. The semiconductor device according to claim 1, further comprising a gate electrode facing the first semiconductor region with the impurity diffusion suppression layer and the second semiconductor region being interposed between the gate electrode and the first semiconductor region.

3. The semiconductor device according to claim 2, further comprising a third semiconductor region interposed between the second semiconductor region and the gate electrode,
wherein the third semiconductor region is made of a III-V compound semiconductor which has a wider band gap than a band gap of the second semiconductor region.

4. A semiconductor device comprising a structure that comprises:
a first semiconductor region;
an impurity diffusion suppression layer;
a second semiconductor region; and
a gate electrode,
wherein the first semiconductor region, the impurity diffusion suppression layer, the second semiconductor region, and the gate electrode are arranged in that order,
the first semiconductor region is made of a III-V compound semiconductor including p-type impurities,
the second semiconductor region is made of a III-V compound semiconductor including n-type impurities, and
the impurity diffusion suppression layer suppresses diffusion of p-type impurities from within the first semiconductor region to the second semiconductor region.

5. A semiconductor device comprising a structure that comprises:
a first semiconductor region;
an impurity diffusion suppression layer;
a second semiconductor region;
a third semiconductor region; and
a gate electrode,
wherein the first semiconductor region, the impurity diffusion suppression layer, the second semiconductor region, the third semiconductor region, and the gate electrode are arranged in that order,
the first semiconductor region is made of a III-V compound semiconductor that includes p-type impurities,
the second semiconductor region is made of a III-V compound semiconductor,
the third semiconductor region is made of a III-V compound semiconductor which has a wider band gap than a band gap of the second semiconductor region, and
the impurity diffusion suppression layer suppresses diffusion of p-type impurities from within the first semiconductor region to the second semiconductor region.

6. The semiconductor device according to claims 2 or 4,
wherein an insulator layer is formed between the second semiconductor region and the gate electrode.

7. The semiconductor device according to claims 3 or 5,
wherein an insulator layer is formed between the third semiconductor region and the gate electrode.

8. A semiconductor device comprising:
a drain electrode;
a drain layer formed on the drain electrode and made of a III-V compound semiconductor that includes a high concentration of n-type impurities;
a low concentration semiconductor region formed on the drain layer and made of a III-V compound semiconductor that includes a low concentration of n-type impurities;
a plurality of first semiconductor regions formed on the low concentration semiconductor region and made of a III-V compound semiconductor that includes p-type impurities, wherein the first semiconductor regions are distributed on the low concentration semiconductor region such that a space is left between adjacent first semiconductor regions;
an impurity diffusion suppression layer formed on the first semiconductor regions;
a second semiconductor region formed on the low concentration semiconductor region and the impurity diffusion suppression layer, wherein the second semiconductor region is made of a III-V compound semiconductor that includes n-type impurities;
a gate insulator layer formed on a part of the second semiconductor region, wherein that part of the second semiconductor region faces the first semiconductor region;
a gate electrode formed on the gate insulator layer; and
a source electrode making electrical contact with a part of the second semiconductor region, wherein that part of the second semiconductor region faces the first semiconductor region.

9. A semiconductor device comprising:
a drain electrode;
a drain layer formed on the drain electrode and made of a III-V compound semiconductor that includes a high concentration of n-type impurities;
a low concentration semiconductor region formed on the drain layer and made of a III-V compound semiconductor that includes a low concentration of n-type impurities;
a plurality of first semiconductor regions formed on the low concentration semiconductor region and made of a III-V compound semiconductor that includes p-type impurities, wherein the first semiconductor regions are distributed on the low concentration semiconductor region such that a space is left between adjacent first semiconductor regions;
an impurity diffusion suppression layer formed on the first semiconductor regions;
a second semiconductor region formed on the low concentration semiconductor region and the impurity diffusion suppression layer, wherein the second semiconductor region is made of a III-V compound semiconductor;
a third semiconductor region formed on the second semiconductor region, wherein the third semiconductor region is made of a III-V compound semiconductor which has a wider band gap than a band gap of the second semiconductor region;
a gate insulator layer formed on a part of the third semiconductor region, wherein that part of the third semiconductor region faces the first semiconductor region;
a gate electrode formed on the gate insulator layer; and
a source electrode making electrical contact with a part of the third semiconductor region,
wherein that part of the third semiconductor region faces the first semiconductor region.

10. The semiconductor device according to claims 8 or 9,
wherein the source electrode also makes contact with the first semiconductor regions.

11. The semiconductor device according to any one of claims 8 to 10,
wherein a part of the low concentration semiconductor region is located in the space between the adjacent first semiconductor regions.

12. The semiconductor device according to claim 11, further comprising a side surface impurity diffusion suppression layer located between said part of the low concentration semiconductor region and the first semiconductor region.

13. The semiconductor device according to any one of claims 8 to 12, further comprising a bottom surface impurity diffusion suppression layer formed between the low concentration semiconductor region and a bottom surface of the first semiconductor region.

14. A semiconductor device comprising:
a low concentration semiconductor region made of a m-V compound semiconductor that includes a low concentration of n-type impurities;
a first semiconductor region formed on a part of the low concentration semiconductor region and made of a III-V compound semiconductor that includes p-type impurities;
an impurity diffusion suppression layer formed on the first semiconductor region;
a second semiconductor region formed on the low concentration semiconductor region and the impurity diffusion suppression layer, wherein the second semiconductor region is made of a III-V compound semiconductor that includes n-type impurities;
a gate insulator layer formed on a part of the second semiconductor region, wherein that part of the second semiconductor region faces the first semiconductor region;
a source electrode making electrical contact with a part of the second semiconductor region, wherein that part of the second semiconductor region faces the first semiconductor region;
a drain electrode making electrical contact with a part of the second semiconductor region, wherein that part of the second semiconductor region does not face the first semiconductor region; and
a gate electrode formed on the gate insulator layer between the source electrode and the drain electrode.

15. A semiconductor device comprising:
a low concentration semiconductor region made of a III-V compound semiconductor that includes a low concentration of n-type impurities;
a first semiconductor region formed on a part of the low concentration semiconductor region and made of a III-V compound semiconductor that includes p-type impurities;
an impurity diffusion suppression layer formed on the first semiconductor region;
a second semiconductor region formed on the low concentration semiconductor region and the impurity diffusion suppression layer, wherein the second semiconductor region is made of a III-V compound semiconductor;
a third semiconductor region formed on the second semiconductor region, wherein the third semiconductor region is made of a III-V compound semiconductor which has a wider band gap than a band gap of the second semiconductor region;
a gate insulator layer formed on a part of the third semiconductor region, wherein that part of the third semiconductor region faces the first semiconductor region;
a source electrode making electrical contact with a part of the third semiconductor region, wherein that part of the third semiconductor region faces the first semiconductor region;
a drain electrode making electrical contact with a part of the third semiconductor region, wherein that part of the third semiconductor region does not faces the first semiconductor region; and
a gate electrode formed on the gate insulator layer between the source electrode and the drain electrode.

16. The semiconductor device according to claims 14 or 15,
wherein the source electrode also makes electrical contact with the first semiconductor region.

17. The semiconductor device according to any one of claims 14 to 16, further comprising:
a side surface impurity diffusion suppression layer formed between a side face of the first semiconductor region and the low concentration semiconductor region.

18. The semiconductor device according to any one of claims 1 to 17,
wherein the impurity diffusion suppression layer is made of one layer or a stack of layers, the layer including one kind of material selected from a group consisting of silicon oxide, silicon nitride, aluminum nitride and aluminum gallium nitride, wherein the stack of layers includes at least one layer including one kind of material and another layer including other kind of material.

19. The semiconductor device according to any one of claims 1 to 18,
wherein the p-type impurities are magnesium.

20. The semiconductor device according to any one of claims 1 to 19,
wherein the III-V compound semiconductors are Al_{X}Ga_{Y}In_{1-X-Y}N (0≤X≤1, 0≤Y≤1, 0≤1-X-Y≤1).

21. A method of manufacturing a semiconductor device comprising:
patterning an impurity diffusion suppression layer on a plurality of portions of a top surface of stacked semiconductor layers which comprise a lower semiconductor layer and an upper semiconductor layer, wherein the lower semiconductor layer is made of a III-V compound semiconductor that includes n-type impurities and the upper semiconductor layer is made of a III-V compound semiconductor that includes p-type impurities;
etching the upper semiconductor layer at an uncovered region thereof with the impurity diffusion suppression layer so that a plurality of trenches penetrates the upper semiconductor layer and reaches the lower semiconductor layer; and
growing a crystal of a III-V compound semiconductor that includes n-type impurities from a surface of the lower semiconductor layer at a bottom of each trench.

22. The method of manufacturing the semiconductor device according to claim 21,
wherein the impurity diffusion suppression layer works as a crystal growth suppression layer, and
the step of growing the crystal of the III-V compound semiconductor is continued until a crystal grows laterally above the impurity diffusion suppression layer from the crystal grown from the bottom of each trench.

23. A method of manufacturing a semiconductor device comprising:
patterning a crystal growth suppression layer on plurality of portions of a top surface of a semiconductor layer, wherein the semiconductor layer is made of a III-V compound semiconductor that includes n-type impurities;
etching the semiconductor layer at an uncovered region thereof with the crystal growth suppression layer so that a plurality of trenches penetrates into the semiconductor layer;
forming an impurity diffusion suppression layer on the side surfaces and the bottom surface of each trench;
removing the impurity diffusion suppression layer formed at the bottom surface of each trench and leaving the impurity diffusion suppression layer formed at the side surfaces of each trench by using an anisotropic etching technique so that side surface impurity diffusion suppression layers are formed on the side surfaces of each trench;
growing a crystal of a III-V compound semiconductor that includes p-type impurities from a surface of the semiconductor layer at the bottom of each trench to form a first semiconductor region, wherein the first semiconductor region does not grow on the crystal growth suppression layer on the semiconductor layer;
forming an upper surface impurity diffusion suppression layer on the first semiconductor regions, wherein the upper surface impurity diffusion suppression layer is not formed on the crystal growth suppression layer on the semiconductor layer;
removing the crystal growth suppression layer on the semiconductor layer; and
growing a crystal of a III-V compound semiconductor that includes n-type impurities from a surface of both the upper surface impurity diffusion suppression layer and the semiconductor layer to form a second semiconductor region.

24. A method of manufacturing a semiconductor device comprising:
patterning a crystal growth suppression layer on a plurality of portions of a top surface of a semiconductor layer, wherein the semiconductor layer is made of a III-V compound semiconductor that includes n-type impurities;
etching the semiconductor layer at an uncovered region thereof with the crystal growth suppression layer so that a plurality of trenches penetrates into the semiconductor layer;
forming an impurity diffusion suppression layer on the side surfaces and the bottom surface of each trench so that a bottom surface impurity diffusion suppression layer is formed at the bottom surface of each trench and side surface impurity diffusion suppression layers are formed at the side surfaces of each trench;
growing a crystal of a III-V compound semiconductor that includes p-type impurities from a surface of the bottom surface impurity diffusion suppression layer at the bottom of each trench to form first semiconductor regions, wherein the first semiconductor region does not grow on the crystal growth suppression layer on the semiconductor layer;
forming an upper surface impurity diffusion suppression layer on the first semiconductor regions, wherein the upper surface impurity diffusion suppression layer is not formed on the crystal growth suppression layer on the semiconductor layer;
removing the crystal growth suppression layer on the semiconductor layer; and
growing a crystal of a III-V compound semiconductor that includes n-type impurities from a surface of both the upper surface impurity diffusion suppression layer and the semiconductor layer to form a second semiconductor region.

25. A method of manufacturing a semiconductor device comprising:
patterning a crystal growth suppression layer on a plurality of portions of a top surface of a semiconductor layer, wherein the semiconductor layer is made of a III-V compound semiconductor that includes n-type impurities;
etching the semiconductor layer at an uncovered regions thereof with the crystal growth suppression layer so that a plurality of trenches penetrates into the semiconductor layer;
forming an impurity diffusion suppression layer on the side surfaces and the bottom surface of each trench;
removing the impurity diffusion suppression layer formed at the bottom surface of each trench and leaving the impurity diffusion suppression layer formed at the side surfaces of each trench by using the anisotropic etching technique so that side surface impurity diffusion suppression layers are formed on the side surfaces of each trench;
growing a crystal of a III-V compound semiconductor that includes p-type impurities from a surface of the semiconductor layer at the bottom of each trench to form a first semiconductor region, wherein the first semiconductor region does not grow on the crystal growth suppression layer on the semiconductor layer;
forming an upper surface impurity diffusion suppression layer on the first semiconductor regions, wherein the upper surface impurity diffusion suppression layer is not formed on the crystal growth suppression layer on the semiconductor layer;
removing the crystal growth suppression layer on the semiconductor layer;
growing a crystal of a III-V compound semiconductor from a surface of both the upper surface impurity diffusion suppression layer and the semiconductor layer to form a second semiconductor region; and
growing a crystal of a third semiconductor region from the surface of the second semiconductor region, wherein the third semiconductor region is made of a III-V compound semiconductor which has a wider band gap than a band gap of the second semiconductor region.

26. A method of manufacturing a semiconductor device comprising:
patterning a crystal growth suppression layer on a plurality of portions of a top surface of a semiconductor layer, wherein the semiconductor layer is made of III-V compound semiconductors that includes n-type impurities;
etching the semiconductor layer at an uncovered regions thereof with the crystal growth suppression layer so that a plurality of trenches penetrates into the semiconductor layer;
forming an impurity diffusion suppression layer on the side surfaces and the bottom surface of each trench so that a bottom surface impurity diffusion suppression layer is formed at the bottom surface of each trench and side surface impurity diffusion suppression layers are formed at the side surfaces of each trench;
growing a crystal of a III-V compound semiconductor that includes p-type impurities from a surface of the bottom surface impurity diffusion suppression layer at the bottom of each trench to form a first semiconductor region, wherein the first semiconductor region does not grow on the crystal growth suppression layer on the semiconductor layer;
forming an upper surface impurity diffusion suppression layer on the first semiconductor region, wherein the upper surface impurity diffusion suppression layer is not formed on the crystal growth suppression layer on the semiconductor layer;
removing the crystal growth suppression layer on the semiconductor layer,
growing a crystal of a III-V compound semiconductor from a surface of both the upper surface impurity diffusion suppression layer and the semiconductor layer to form a second semiconductor region; and
growing a crystal of a third semiconductor region from a surface of the second semiconductor region, wherein the third semiconductor region is made of a III-V compound semiconductor which has a wider band gap than a band gap of the second semiconductor region.
